# EUROPÄISCHE PATENTSCHRIFT

(11) **EP 4 236 064 B1**
(45) Veröffentlichungstag und Bekanntmachung des Hinweises auf die Patenterteilung: **18.11.2026**
(21) Anmeldenummer: 23173028.4
(22) Anmeldetag: 18.03.2021
(51) Int. Cl.: G01S 5/02, H03D 7/16, H04W 56/00, G01S 5/14, H04W 4/33

(54) **VERFAHREN UND SYSTEM ZUM ABGLEICHEN DER SENDER-CLOCKFREQUENZ UND DER EMPFÄNGER-CLOCKFREQUENZ, VERFAHREN UND SYSTEM ZUM ABGLEICHEN EINER MISCHFREQUENZ UND EINER TRÄGERFREQUENZ, VERFAHREN UND SYSTEM ZUR POSITIONSBESTIMMUNG**
METHOD AND SYSTEM FOR MATCHING THE TRANSMITTER CLOCK FREQUENCY AND THE RECEIVER CLOCK FREQUENCY, METHOD AND SYSTEM FOR MATCHING A MIXING FREQUENCY AND A CARRIER FREQUENCY, METHOD AND SYSTEM FOR POSITION DETERMINATION
PROCÉDÉ ET SYSTÈME POUR FAIRE CORRESPONDRE LA FRÉQUENCE D'HORLOGE D'ÉMETTEUR ET LA FRÉQUENCE D'HORLOGE DE RÉCEPTEUR, PROCÉDÉ ET SYSTÈME POUR FAIRE CORRESPONDRE UNE FRÉQUENCE DE MÉLANGE ET UNE FRÉQUENCE PORTEUSE, PROCÉDÉ ET SYSTÈME DE DÉTERMINATION DE POSITION

(30) Priorität: 20.05.2020 DE 102020113742
(43) Veröffentlichungstag der Anmeldung: 30.08.2023
(62) Dokumentnummer(n) der früheren Anmeldung(en) nach Art. 76 EPÜ: 21715781.7 / 4 154 624
(73) Patentinhaber: Forschungszentrum Jülich GmbH, 52425 Jülich (DE)
(72) Erfinder: Grewing, Christian, 52428 Jülich (DE); Van Waasen, Stefan, 41836 Hückelhoven (DE); Zambanini, André, 52064 Aachen (DE); Robens, Markus, 52074 Aachen (DE); Liebau, Daniel, 41541 Dormagen (DE)
(74) Vertreter: Paul & Albrecht Patentanwälte PartG mbB

(56) Entgegenhaltungen:
- EP-A2- 1 031 845
- DE-A1- 102005 050 229
- KR-B1- 102 093 045
- US-A1- 2019 260 619
- US-B1- 10 015 769

## Beschreibung

Die Erfindung betrifft ein Verfahren und System zum Abgleichen der Mischfrequenz eines Mischers eines Empfängers und der Trägerfrequenz eines von dem Empfänger empfangenen Signals sowie ein Verfahren und ein System zur Positionsbestimmung, insbesondere Indoor-Positionsbestimmung.

Bei einer Empfangsstrecke eines digitalen Systems mit wenigstes einem Sender und wenigstens einem Empfänger nutzen sowohl Sender als auch Empfänger eine digitale Taktfrequenz, die auch als Clockfrequenz bezeichnet wird. Eine mögliche Fehlerquelle in einem solchen Empfangszug liegt in einer nicht abgeglichenen Taktfrequenz des Senders und Empfängers.

Solche Empfangsstrecken mit Sendern und Empfängern finden sich beispielsweise bei Systemen zur Positionsbestimmung, die insbesondere innerhalb von Gebäuden zum Einsatz kommen können. Man spricht auch von Systemen zur Indoor-Positionsbestimmung bzw. Indoor-Positioniersystemen. Indoor-Funk-Kommunikationssysteme sind beispielsweise in der Veröffentlichung "Propagation data and prediction methods for the planning of indoor radiocommunication systems and radio local area networks in the frequency range 900 MHz to 100 GHz", Recommendation ITU-R P.1238-7 (02/2012) der International Telecommunication Union, bzw. des Radiocommunication Sectors dieser, thematisiert.

Die KR 102 093 045 B1 offenbart ein Verfahren und eine Vorrichtung zum Einstellen der Clock eines Empfängers, der von einem Sender gesendete Daten empfängt.

Aus dem Stand der Technik sind verschiedene Techniken vorbekannt, um aus den empfangenen Daten in einem Sender einer digitalen Empfangsstrecke die Clockfrequenz des Senders, also die Sender-Clockfrequenz, zu extrahieren. Sie werden sowohl in draht- und fasergebundenen Systemen als auch in kabellosen Systemen verwendet Die Frequenz ist aber hinlänglich genau durch das Matching der frequenzgebenden Komponenten, etwas eines Quarzes im Sender bzw. im Empfänger, gegeben. Es wird oftmals ein reiner Phasenvergleich der Daten mit der Empfängerclock zum Frequenzabgleich benutzt, da dieser einfach und ohne großen Aufwand realisierbar ist.

Es kann wünschenswert sein, das empfangene Signal in einem Positioniersystem mit sehr hoher Zeitauflösung zu untersuchen. Nach Auffassung der Anmelderin ist es erstrebenswert, die Ankunftszeit (englisch: Time of Arrival, kurz ToA) des Empfangssignales mit einer Auflösung im Pikosekunden-Bereich zu bestimmen, insbesondere, um eine besonders hohe Ortsauflösung, beispielsweise 1 mm oder darunter, zu gewährleisten. Würde man die Clockfrequenzen entsprechend erhöhen, wäre ein sehr hoher Stromverbrauch erforderlich, weshalb dies in der Regel nicht umsetzbar ist.

Eine Alternative besteht aus Sicht der Anmelderin darin, Sender und Empfänger mit Clocks arbeiten zu lassen, die einen sehr kleinen aber genauen Frequenzunterschied haben. Man kann auch von inkommensurablen Clockfrequenzen sprechen. Dann wäre ein virtuelle Überabtastung ohne den erhöhten Stromverbrauch möglich.

Bei einem Positionierungssystem besteht das Sendesignal oftmals aus einer festen Symbolfolge, einem sogenannten Chip. Dieser Chip wird immer wiederholt und bei den konventionellen Systemen die Phase des Chipsignales zur Ankunftszeitbestimmung genutzt. Um eine virtuelle Überabtastung zu ermöglichen, könnte anstelle eines Chips eine Anzahl aufeinanderfolgender Chips benutzt werden. Die aufeinanderfolgenden Chips können auch als auch als Sequenz bezeichnet werden. Der Frequenzunterschied wäre dann so zu wählen, dass Sender und Empfänger-Clock nach einer Signalsequenz wieder gleich sind, also eine gemeinsame subharmonische Frequenz besitzen. Ein genauer Abgleich dieser Frequenzen wäre notwendig, aber mit den vorbekannten Methoden nicht möglich, da bei inkommensurablen Clockfrequenzen die Phase der beiden Clockfrequenzen nicht gleich ist, sondern sich zyklisch zueinander verändert.

Es ist daher Aufgabe der vorliegenden Erfindung, eine Möglichkeit für einen Abgleich inkommensurabler Clockfrequenzen zu schaffen. Darüber hinaus ist es Aufgabe der Erfindung, ein Verfahren und System zur Positionsbestimmung, insbesondere Indoor-Positionsbestimmung anzugeben, die eine hohe Ortsauflösung bei gleichzeitig vertretbarer Stromverbrauch gewährleisten.

Offenbart ist ein Verfahren zum Abgleichen der Sender-Clockfrequenz eines ein Signal bevorzugt kabellos sendenden Senders und der Empfänger-Clockfrequenz eines das Signal empfangenden Empfängers, wobei sich das von dem Sender gesendete Signal durch eine Trägerfrequenz und eine Modulationsfrequenz auszeichnet, bevorzugt, wobei die Modulationsfrequenz der Sender-Clockfrequenz entspricht oder in einem festen, bevorzug ganzzahligen Verhältnis zu der Sender-Clockfrequenz steht, insbesondere eine Harmonische oder Subharmonische der Sender-Clockfrequenz ist, bei dem
- das Signal einem Mischer, Frequenzabgleich-Mischer, in dem ein Mischen, insbesondere Runtermischen mit einer Mischfrequenz erfolgt, die der Empfänger-Clockfrequenz entspricht oder in einem festen, bevorzugt ganzzahligen Verhältnis zu der Empfänger-Clockfrequenz steht, insbesondere eine Harmonische oder Subharmonische der Empfänger-Clockfrequenz ist, zugeführt wird, insbesondere, um ein Ausgangssignal zu erhalten, das eine Frequenzkomponente enthält, die der aktuellen Differenz zwischen der Sender-Clockfrequenz und der Empfänger-Clockfrequenz entspricht,
- ermittelt wird, ob die Frequenzkomponente des Ausgangssignals des Frequenzabgleich-Mischers in einem festen, bevorzug ganzzahligen Verhältnis zu der Empfänger-Clockfrequenz steht, insbesondere eine Harmonische oder Subharmonische der Empfänger-Clockfrequenz ist, und
- für den Fall, dass dem nicht so ist, die Empfänger-Clockfrequenz und/oder die Sender-Clockfrequenz angepasst wird, bevorzug derart, dass dies der Fall ist.

Weiterhin offenbart ist ein System zum Abgleichen einer Sender-Clockfrequenz und einer Empfänger-Clockfrequenz, umfassend wenigstens einen Mischer, Frequenzabgleich-Mischer, und wenigstens ein Verzögerungselement, wobei das System zur Durchführung des offenbarten Verfahrens zum Abgleichen der Sender-Clockfrequenz eines ein Signal bevorzugt kabellos sendenden Senders und der Empfänger-Clockfrequenz eines das Signal empfangenden Empfängers ausgebildet und eingerichtet ist.

Offenbart ist auch ein Verfahren zur Positionsbestimmung, insbesondere Indoor-Positionsbestimmung, eines Empfängers, der von mehreren Sendern jeweils ein Signal bevorzugt kabellos empfängt, das sich durch eine Trägerfrequenz und eine Modulationsfrequenz auszeichnet, wobei sich die Trägerfrequenzen verschiedener Sender voneinander unterscheiden, und die Modulationsfrequenz für aller Sender gleich ist, bevorzugt, wobei die Modulationsfrequenz der Sender-Clockfrequenz entspricht oder in einem festen, bevorzug ganzzahligen Verhältnis zu der Sender-Clockfrequenz steht, insbesondere eine Harmonische oder Subharmonische der Sender-Clockfrequenz ist, und die empfangenen Signale von dem Empfänger empfangen werden, bei dem wenigstens ein Mal unter Durchführung des Verfahrens zum Abgleichen der Sender- und der Empfänger-Clockfrequenz die Empfänger-Clockfrequenz und die Sender-Clockfrequenz wenigstens eines der Sender abgeglichen werden, und anschließend die Positionsbestimmung erfolgt.

Offenbart ist auch ein System zur Positionsbestimmung, insbesondere zur Durchführung des offenbarten Verfahrens zur Positionsbestimmung, umfassend wenigstens einen Empfänger und mehrere Sender, wobei die jeweils dazu ausgebildet und/oder eingerichtet sind, Signale insbesondere kabellos auszusenden, die sich jeweils durch eine Trägerfrequenz und eine Modulationsfrequenz auszeichnen, wobei sich die Trägerfrequenzen verschiedener Sender voneinander unterscheiden, und die Modulationsfrequenz für aller Sender gleich ist, bevorzugt, wobei die Modulationsfrequenz der Sender-Clockfrequenz des jeweiligen Senders entspricht oder in einem festen, bevorzug ganzzahligen Verhältnis zu der Sender-Clockfrequenz des jeweiligen Senders steht, insbesondere eine Harmonische oder Subharmonische der Sender-Clockfrequenz des jeweiligen Senders ist, und ein System zum Abgleichen einer Sender-Clockfrequenz und einer Empfänger-Clockfrequenz.

Es gilt insbesondere, dass sich die (jeweilige) Sender- und Empfänger-Clockfrequenz voneinander unterscheiden bzw. voneinander unterscheiden sollen. Dies insbesondere zur Realisierung einer virtuellen Überabtastung. Man kann auch sagen, dass es sich um inkommensurable Clockfrequenzen handelt. Der gewünschte Frequenzunterschied für die virtuelle Überabtastung kann beispielsweise im Bereich von PPM (Parts per Million) der Sender- und/oder Empfänger-Clockfrequenz liegen. Er kann zum Beispiel einige kHz betragen, wenn die Größenordnung der Sender- und/oder Empfänger-Clockfrequenz beispielsweise im Bereich von einigen hundert MHz liegt. Als beispielhafte Werte seien eine Trägerfrequenz von 5 GHz, eine Sender-Clockfrequenz von 500 MHz, eine Modulationsfrequenz von 1 MHz und eine Frequenzabweichung (df) zwischen Sender- und Empfänger-Clockfrequenz von 1 kHz, also 2 PPM, genannt.

Beschrieben ist mit anderen Worten der Grundgedanke, für die Frequenzabstimmung das Empfangssignal im Empfänger derart zu modulieren, dass ein Signal generiert wird, das eine Frequenzkomponente enthält, die dem Offset der beiden Clockfrequenzen, also dem Offset zwischen Sender- und Empfänger-Clockfrequenz entspricht. Da diese in einem festen Verhältnis zu der Empfänger-Clockfrequenz steht bzw. stehen soll, insbesondere eine Harmonische oder Subharmonische dieser ist bzw. sein soll, kann der Abgleich durch Frequenzvergleich der Offsetfrequenz mit der Empfänger-Clockfrequenz erfolgen. Man kann auch sagen, die Clock- Offsetfrequenz wird mit der Empfänger-Clockfrequenz vermessen.

Der bzw. die Sender und/oder der bzw. die Empfänger sind bevorzugt Teil einer digitalen Sende- und Empfangsstrecke. Für den Fall eines Systems zur Positionsbestimmung, insbesondere zu Indoor-Positionsbestimmung, sind die Sender zweckmäßiger Weise an verschiedenen Stellen, also voneinander beabstandet, ortsfest angeordnet bzw. für eine ortsfeste Anordnung an verschiedenen, voneinander beabstandeten Stellen bestimmt. Beispielsweise kann ein Raum mit mehreren, an verschiedenen Stellen ortsfest angeordneten Sendern ausgestattet sein bzw. werden, zum Beispiel mit acht Stück, von denen sich jeweils einer in einer Ecke des Raumes befindet bzw. dort angeordnet wird. Man kann bei den Sendern eines Systems zur Positionsbestimmung auch von Basisstationen sprechen. Von dem Empfänger oder, im Falle mehrerer, den Empfängern, der frei bewegbar ist bzw. die frei bewegbar sind, kann dann die Position bestimmt werden, dies insbesondere in an sich vorbekannter Weise in Abhängigkeit von Signalen, die von den Sendern gesendet und dem (jeweiligen) Empfänger empfangen werden. Insbesondere aus den Laufzeitunterschieden der Signale von dem jeweiligen Sender zum Empfänger kann die Positionsbestimmung erfolgen. Der (jeweilige) Empfänger kann auch als mobiles Gerät bezeichnet werden bzw. Teil eines solchen sein.

Das von dem Sender gesendete Signal wird insbesondere zunächst von dem Empfänger empfangen und anschließend an dem Frequenzabgleich-Mischer zugeführt. Nach dem Empfang und vor dem Zuführen zu dem Frequenzabgleich-Mischer kann das Signal noch weiterverarbeitet werden.

Die Frequenzen in dem Sender und Empfänger, insbesondere die Senderund Empfänger-Clockfrequenz, werden bevorzugt mit einem Frequenzgenerator aus der Frequenz eines Quarzoszillators jeweils im Sender und Empfänger erzeugt bzw. sind auf diese Weise erzeugt worden. Der jeweilige Frequenzgenerator erzeugt ein Signal mit einer Frequenz, das in einem festen Verhältnis zur Frequenz des jeweiligen Quarzoszillators steht (Frequenzumsetzungsfaktor). Dieser Frequenzumsetzungsfaktor kann hochgenau eingestellt werden, um eine eventuelle, nicht gewollte Differenz der beiden Quarzoszillatoren von Sender und Empfänger zu kompensieren. Im Rahmen der vorliegenden Erfindung ist zweckmäßiger Weise der Frequenzumsetzungsfaktor im Sender von dem Frequenzumsetzungsfaktor im Empfänger verschieden.

Bei der Sender- und Empfänger-Clockfrequenz handelt es sich insbesondere um digitale Clockfrequenzen.

Der Empfänger ver- bzw. bearbeitet das empfangene Signal zweckmäßiger Weise mit der Empfänger-Clockfrequenz. Der Empfänger tastet das empfangene Signal insbesondere mit der Empfänger-Clockfrequenz oder mit einer Frequenz, die in einem festen, bevorzug ganzzahligen Verhältnis zu der Empfänger-Clockfrequenz steht, insbesondere eine Harmonische oder Subharmonische der Empfänger-Clockfrequenz ist, ab.

Das System zum Abgleichen einer Sender-Clockfrequenz und einer Empfänger-Clockfrequenz bildet bevorzugt einen Bestandteil eines Systems zur Positionsbestimmung. Es kann insbesondere einem Empfänger eines solches zugeordnet sein. Besonders bevorzugt ist es als Bestandteile eines Empfängers eines solchen ausgebildet. Es ist auch nicht ausgeschlossen, dass ein System zum Abgleichen einer Sender-Clockfrequenz und einer Empfänger-Clockfrequenz separat zu einem Positionierungssystem bzw. Empfänger eines solchen ausgebildet ist. Dann bekommt es zweckmäßiger Weise die Empfänger-Clockfrequenz übergeben, wobei es hierfür mit dem Positionierungssystem, insbesondere Empfänger eines solchen, gekoppelt oder koppelbar ist.

Dass sich das Signal des oder des jeweiligen Senders durch eine Trägerfrequenz und eine Modulationsfrequenz auszeichnet bedeutet insbesondere, dass ein Trägersignal einer gegebenen Trägerfrequenz vorliegt, das moduliert ist und zwar mit der Modulationsfrequenz. Besonders bevorzugt handelt es sich um ein sinusförmiges Trägersignal der Trägerfrequenz, dessen Phase sich mit der Modulationsfrequenz ändert, insbesondere jeweils um 180°.

Eine besonders vorteilhafte Ausführungsform des Verfahrens zum Abgleich von Sender- und Empfänger-Clockfrequenz zeichnet sich dadurch aus, dass die Ermittlung, ob die Frequenzkomponente des Ausgangssignals des Frequenzabgleich-Mischers in einem festen Verhältnis zu der Empfänger-Clockfrequenz steht, mit einschließt oder dadurch erfolgt, dass das Ausgangssignal des Frequenzabgleich-Mischers einerseits wenigstens einem Verzögerungselement zugeführt wird, um wenigstens ein Verzögerungssignal zu erhalten, und das Ausgangssignal des Frequenzabgleich-Mischers andererseits an dem wenigstens einen Verzögerungselement vorbeigeführt wird, um zusätzlich ein unverzögertes Signal zu erhalten, und die Differenz und/oder Summe aus dem oder wenigstens einem der Verzögerungssignale und dem unverzögerten Signal gebildet und als Kontrollwert erachtet wird, und davon ausgegangen wird, dass die Frequenzkomponente des Ausgangssignals des Frequenzabgleich-Mischers in einem festen Verhältnis zu der Empfänger-Clockfrequenz steht, wenn die Differenz einen minimalen Wert hat und/oder wenn die Summe einen maximalen Wert hat, bevorzugt, wobei für den Fall, dass die Differenz keinen minimalen Wert hat, die Empfänger-Clockfrequenz und/oder die Sender-Clockfrequenz derart angepasst wird, dass die Differenz reduziert, insbesondere ein minimaler Wert dieser erhalten wird, und/oder für den Fall, dass die Summe keinen maximalen Wert hat, die Empfänger-Clockfrequenz und/oder die Sender-Clockfrequenz derart angepasst wird, dass die Summe erhöht, insbesondere ein maximaler Wert dieser erhalten wird.

Bei dem angestrebten Minimum kann es sich, insbesondere aufgrund der Periodizität, um ein lokales Minimum handeln. Gleiches kann -im Falle der Summenbildung - für das Maximum gelten.

Dann ist zweckmäßiger Weise vorgesehen, dass das Ausgangssignal des Frequenzabgleich-Mischers zum Erhalt des oder wenigstens eines der Verzögerungssignale einem oder mehreren Verzögerungselementen zugeführt wird, das, insbesondere im eingeschwungen Zustand, eine Verzögerung bedingt, oder die zusammengenommen, insbesondere im eingeschwungenen Zustand, eine Verzögerung bedingen, die dem reziproken Wert einer Frequenz entspricht, die in einem festen, bevorzug ganzzahligen Verhältnis zu der Empfänger-Clockfrequenz steht, insbesondere eine Harmonische oder Subharmonische der Empfänger-Clockfrequenz ist, oder die einem Vielfachen dieses reziproken Wertes entspricht.

Die Verzögerung, die dem reziproken Wert einer Frequenz entspricht, die in einem festen, bevorzug ganzzahligen Verhältnis zu der Empfänger-Clockfrequenz steht, insbesondere eine Harmonische oder Subharmonische der Empfänger-Clockfrequenz ist, oder die einem Vielfachen dieses reziproken Wertes entspricht, kann mit anderen Worten mittels nur eines Verzögerungselementes bedingt werden, oder mit mehreren, die dann zweckmäßiger Weise jeweils einen Anteil an dieser Verzögerung haben, und denen das Signal zweckmäßiger Weise nacheinander zugeführt wird, um in Summe diese Verzögerung zu erhalten.

Ein Verzögerungselement kann beispielsweise durch eines oder mehrere Flipflops realisiert sein oder eines oder mehrere Flipflops umfassen. Das heißt dann insbesondere, dass das Signal um einen Clockzyklus verzögert wird. So kann eine Verzögerung durch genau eine Clockperiode bewirkt werden.

Bevorzugt gilt, dass das oder wenigstens eines der Verzögerungselemente, im Falle mehrerer bevorzugt alle Verzögerungselemente, ein Flipflop bzw. eine Anzahl Flipflops umfassen, die der Bitbreite des Signals entsprechen oder dadurch gebildet sind. Dies stellt eine sehr einfache, kleine und leistungsarme Implementierung dar.

Das System zum Abgleichen der Sender- und Empfänger-Clockfrequenz zeichnet sich zweckmäßiger Weise dadurch aus, dass der Frequenzabgleich-Mischer dazu ausgebildet und/oder eingerichtet ist, ein Mischen, insbesondere Heruntermischen mit einer Mischfrequenz zu realisieren, die der Empfänger-Clockfrequenz entspricht oder in einem festen, bevorzugt ganzzahligen Verhältnis zu der Empfänger-Clockfrequenz steht, insbesondere eine Harmonische oder Subharmonische der Empfänger-Clockfrequenz ist.

Das oder die Verzögerungselemente können Bestandteil einer Frequenzabgleichseinheit sein.

Das oder eines der Verzögerungselemente kann weiterhin dazu ausgebildet und/oder eingerichtet sein, insbesondere im eingeschwungen Zustand, eine Verzögerung zu bedingen, oder mehrere der Verzögerungselemente können weiterhin dazu ausgebildet und/oder eingerichtet sein zusammengenommen, insbesondere im eingeschwungen Zustand, eine Verzögerung zu bedingen, die dem reziproken Wert einer Frequenz entspricht, die in einem festen, bevorzug ganzzahligen Verhältnis zu der Empfänger-Clockfrequenz steht, insbesondere eine Harmonische oder Subharmonische der Empfänger-Clockfrequenz ist, oder die einem Vielfachen dieses reziproken Wertes entspricht.

Das System zum Abgleichen von Sender- und Empfänger-Clockfrequenz umfasst weiter bevorzugt wenigstens eine Auswerte- und Steuereinheit, die dazu ausgebildet und/oder eingerichtet ist, die Differenz und/oder Summe aus einem Signal, das mit dem Verzögerungselement oder den Verzögerungselementen verzögert wurde, und einem unverzögerten Signal zu ermitteln, und bei Bedarf ein Steuersignal zur Anpassung der Empfänger-Clockfrequenz und/oder der Sender-Clockfrequenz auszugeben oder die Empfänger-Clockfrequenz und/oder die Sender-Clockfrequenz anzupassen, bevorzugt derart, dass die Differenz reduziert, insbesondere auf einen minimalen Wert gebracht wird, und/oder dass die Summe erhöht, insbesondere auf einen maximalen Wert gebracht wird. Bedarf besteht in der Regel dann, wenn die ermittelte Differenz nicht den minimalen Wert hat und/oder die ermittelte Summe nicht den maximalen.

Ob Bedarf besteht, kann an einem initial erhaltenen Differenzwert alleine - sofern kein weiterer Bezugspunkt bzw. -wert existiert - ggf. nicht ablesbar sein. Dies insbesondere aus dem Grunde, dass aufgrund von Rauschen das Minimum der Differenz nicht Null betragen muss. Ob das Minimum vorliegt oder nicht, kann beispielsweise ermittelt werden, indem die Empfänger- oder Sender-Clockfrequenz versuchsweise verändert wird, zweckmäßiger Weise in beide Richtungen, und abgelesen wird, ob bzw. in welche Richtung sich die Differenz verkleinert. Auch die Frage, ob im Falle der Summenbildung das Maximum vorliegt, kann durch Probieren ermittelt werden.

Es ist auch möglich, hier zusätzliche Orientierung zu bieten, damit die versuchsweise Änderung nicht entfallen und direkt eine gezielte Anpassung erfolgen kann.

Eine weitere, besonders vorteilhaften Ausgestaltung des Verfahrens zeichnet sich daher dadurch aus, dass ein erstes, zweites und drittes Verzögerungselement vorgesehen sind, und das Ausgangssignal des Frequenzabgleich-Mischers mit dem ersten Verzögerungselement verzögert wird, wodurch eine erstes Verzögerungssignal erhalten wird, und das Ausgangssignal des Frequenzabgleich-Mischers mit dem ersten und dem zweiten Verzögerungselement verzögert wird, wodurch ein zweites Verzögerungssignal erhalten wird, und das Ausgangssignal des Frequenzabgleich-Mischers mit dem ersten, zweiten und dritten Verzögerungselement verzögert wird, wodurch ein drittes Verzögerungssignal erhalten wird. Dann wird die Differenz zwischen dem unverzögerten Signal und dem zweiten Verzögerungssignal gebildet und als der Kontrollwert erachtet, und/oder die Summe aus dem unverzögerten Signal und dem zweiten Verzögerungssignal gebildet und als der Kontrollwert erachtet, und die Differenz zwischen dem ersten und dem zweiten Verzögerungssignal gebildet und als zusätzlicher hoher Kontrollwert erachtet, und/oder die Differenz zwischen dem ersten und dem zweiten Verzögerungssignal gebildet und als zusätzlicher hoher Kontrollwert erachtet, und die Differenz aus dem unverzögerten Signal und dem dritten Verzögerungssignal gebildet und als zusätzlicher niedriger Kontrollwert erachtet und/oder die Summe aus dem unverzögerten Signal und dem dritten Verzögerungssignal gebildet und als zusätzlicher niedriger Kontrollwert erachtet. Von dem Verhältnis des oder des jeweiligen hohen und des oder des jeweiligen niedrigen Kontrollwertes wird dann darauf geschlossen, ob die Sender-Clockfrequenz vergrößert oder verkleinert werden muss und/oder, ob die Empfänger-Clockfrequenz vergrößert oder verkleinert werden muss.

Bevorzugt kann dabei vorgesehen sein, dass das erste und das dritte Verzögerungselement eine beliebige Verzögerung bedingen, und/oder das erste und das zweite Verzögerungselement zusammengenommen diejenige Verzögerung bedingen, die dem reziproken Wert einer Frequenz entspricht, die in einem festen, bevorzug ganzzahligen Verhältnis zu der Empfänger-Clockfrequenz steht, insbesondere eine Harmonische oder Subharmonische der Empfänger-Clockfrequenz ist, oder die dem Vielfachen dieses reziproken Wertes entspricht.

In analoger Weise zu dieser bevorzugten Ausgestaltung des Verfahrens kann sich das System zum Abgleichen von Sender- und Empfänger- Clockfrequenz in Weiterbildung dadurch auszeichnen, dass es ein erstes, zweites und drittes Verzögerungselement vorgesehen ist und das System ausgebildet und/oder eingerichtet ist, um ein mit dem ersten Verzögerungselement verzögertes erstes Verzögerungssignal zu erhalten, und um ein mit dem ersten und dem zweiten Verzögerungselement verzögertes zweites Verzögerungssignal zu erhalten, und um ein mit dem ersten, zweiten und dritten Verzögerungselement verzögertes drittes Verzögerungssignal zu erhalten. Die Auswerte- und Steuereinheit ist dann zweckmäßiger Weise dazu ausgebildet und/oder eingerichtet, die Differenz aus dem unverzögerten Signal und dem zweiten Verzögerungssignal zu bilden, die als Kontrollwert erachtet werden kann, und/oder die Summe aus dem unverzögerten Signal und dem zweiten Verzögerungssignal zu bilden, die als Kontrollwert erachtet werden kann, und die Differenz aus dem ersten und dem zweiten Verzögerungssignal zu bilden, die als zusätzlicher hoher Kontrollwert erachtet werden kann, und/oder die Summe aus dem ersten und dem zweiten Verzögerungssignal zu bilden, die als zusätzlicher hoher Kontrollwert erachtet werden kann, und die Differenz aus dem unverzögerten Signal und dem dritten Verzögerungssignal zu bilden, die als zusätzlicher niedriger Kontrollwert erachtet werden kann, und/oder die Summe aus dem unverzögerten Signal und dem dritten Verzögerungssignal zu bilden, die als zusätzlicher niedriger Kontrollwert erachtet werden kann, und um in Abhängigkeit des Verhältnisses des hohen und des niedrigen Kontrollwertes ein Steuersignal zur Vergrößerung oder Verkleinerung der Sender-Clockfrequenz und/oder zur Vergrößerung oder Verkleinerung der Empfänger-Clockfrequenz auszugeben, und/oder um die Sender-Clockfrequenz zu vergrößern oder zu verkleinern und/oder die Empfänger-Clockfrequenz zu vergrößern oder zu verkleinern.

Weiter bevorzugt sind dann das erste und das dritte Verzögerungselement derart ausgebildet und/oder eingerichtet, dass sie eine beliebige Verzögerung bedingen, und/oder ist das zweite Verzögerungselement derart ausgebildet und/oder eingerichtet ist, dass es zusammengenommen mit dem ersten Verzögerungselement diejenige Verzögerung bedingt, die dem reziproken Wert einer Frequenz entspricht, die in einem festen, bevorzug ganzzahligen Verhältnis zu der Empfänger-Clockfrequenz steht, insbesondere eine Harmonische oder Subharmonische der Empfänger-Clockfrequenz ist, oder die dem Vielfachen dieses reziproken Wertes entspricht.

Für den Fall, dass das Verhältnis des niedrigen zum hohen Kontrollwert größer 1 ist, also der niedrige Kontrollwert größer als der hohe Kontrollwert ist, wird zweckmäßiger Weise die Empfänger-Clockfrequenz gesenkt oder die Sender-Clockfrequenz erhöht. Für den Fall, dass das Verhältnis des niedrigen zum hohen Kontrollwert kleiner 1 ist, also der niedrige Kontrollwert kleiner als der hohe Kontrollwert ist, wird zweckmäßiger Weise die Empfänger-Clockfrequenz erhöht oder die Sender-Clockfrequenz gesenkt. Sind der hohe und der niedrige Kontrollwert gleich groß, erfolgt bevorzugt keine Anpassung der Empfänger- und/oder Sender-Clockfrequenz. Dies wird in der Regel nur der Fall sein, wenn das Kontrollsignal (zufällig) bereits den minimalen Wert hat und entsprechend die Frequenzkomponente des Ausgangssignals des Frequenzabgleich-Mischers in einem festen, bevorzug ganzzahligen Verhältnis zu der Empfänger-Clockfrequenz steht, insbesondere eine Harmonische oder Subharmonische der Empfänger-Clockfrequenz ist. Das System, insbesondere eine Auswerte- und Steuereinheit dieses ist bevorzugt entsprechend ausgebildet und/oder eingerichtet, insbesondere, um Steuersignale für entsprechende Anpassungen auszugeben.

Es sei angemerkt, dass es zwar zur Anpassung der Differenz bzw. Summe aus der Sender- und Empfänger-Clockfrequenz prinzipiell keinen Unterschied macht, ob die Empfänger- oder Senderclock verändert wird. Da das empfängerseitige Signal betrachtet wird, wird es jedoch, zumindest für den Fall, dass die Auswertung bei dem oder nahe des Empfängers erfolgt, eine Anpassung der Empfänger-Clock in der Regel leichter zu realisieren sein. Ein weiterer Vorteil besteht darin, dass dann nicht die Clock mehrere Sender sondern nur die des oder des jeweiligen Empfängers anzupassen ist.

Es hat sich als ganz besonders vorteilhaft erwiesen, für den Frequenzabgleich eines oder mehrere Verzögerungselemente zu nutzen. Das oder die Verzögerungselemente können, wie vorstehend beschrieben, in vorteilhafter Ausgestaltung eines oder mehrere Flipflops umfassen bzw. dadurch gegeben sein.

Gegenstand der Erfindung ist ein Verfahren zum Abgleichen der Mischfrequenz eines Mischers eines Empfängers und der Trägerfrequenz eines von dem Empfänger empfangenen Signals, bei dem ein Signal von dem Empfänger empfangen wird, das eine Trägerfrequenz ohne Modulation aufweist, und das Signal in dem Mischer mit einer Mischfrequenz gemischt, insbesondere heruntergemischt wird, und das erhaltene Ausgangsignal des Mischer einerseits wenigstens einem Verzögerungselement, zugeführt wird, um wenigstens ein Verzögerungssignal zu erhalten, und das Ausgangssignal des Mischers andererseits an dem wenigstens einen Verzögerungselement vorbeigeführt wird, um zusätzlich ein unverzögertes Signal zu erhalten, und die Differenz und/oder Summe aus dem oder wenigstens einem der Verzögerungssignale und dem unverzögerten Signal ermittelt und als Kontrollwert erachtet wird, und die Mischfrequenz des Mischers bei Bedarf derart angepasst wird, dass die Differenz reduziert, insbesondere ein minimaler Wert dieser erhalten wird, und/oder dass die Summe erhöht, insbesondere ein maximaler Wert dieser erhalten wird.

Die Erfindung betrifft ferner ein System zum Abgleichen einer Mischfrequenz eines Mischers und einer Trägerfrequenz eines von einem Empfänger empfangenen Signals, umfassend wenigstens einen insbesondere dem Empfänger zugeordneten oder von dem Empfänger umfassten Mischer und wenigstens ein Verzögerungselement, wobei das System zur Durchführung des erfindungsgemäßen Verfahrens zum Abgleichen der Mischfrequenz eines Mischers eines Empfängers und der Trägerfrequenz eines von dem Empfänger empfangenen Signals ausgebildet und/oder eingerichtet ist.

Das Trainingssignal zeichnet sich durch eine Trägerfrequenz ohne Modulation aus, es ist mit anderen Worten unmoduliert.

In Weiterbildung kann sich das erfindungsgemäße Verfahren zum Abgleichen der Mischfrequenz eines Mischers eines Empfängers und der Trägerfrequenz eines von dem Empfänger empfangenen Signals dadurch auszeichnen, dass das Ausgangssignal des Mischers zum Erhalt des oder wenigstens eines der Verzögerungssignale einem oder mehreren Verzögerungselementen zugeführt wird, das, insbesondere im eingeschwungen Zustand, eine Verzögerung bedingt, oder die zusammengenommen, insbesondere im eingeschwungenen Zustand, eine Verzögerung bedingen, die dem reziproken Wert einer vorgegebenen Frequenz oder einem Vielfachen des reziproken Werts einer vorgegebenen Frequenz entspricht.

Die Periode der Trägerfrequenz zeichnet sich bevorzugt dadurch aus, dass deren Unterschied zu der Periode der Mischfrequenz des Mischers derjenigen Verzögerung entspricht, die durch das oder wenigstens eines der Verzögerungselemente bedingt wird. Sie wird insbesondere explizit so gewählt bzw. eingestellt.

Besonders bevorzugt gilt auch hier, dass ein erstes, zweites und drittes Verzögerungselement vorgesehen ist, und das Ausgangssignal des Mischers mit dem ersten Verzögerungselement verzögert wird, wodurch eine erstes Verzögerungssignal erhalten wird, und das Ausgangssignal des Mischers mit dem ersten und dem zweiten Verzögerungselement verzögert wird, wodurch ein zweites Verzögerungssignal erhalten wird, und das Ausgangssignal des Mischers mit dem ersten und dem zweiten und dem dritten Verzögerungselement verzögert wird, wodurch ein drittes Verzögerungssignal erhalten wird. Dann kann die Differenz aus dem unverzögerten Signal und dem zweiten Verzögerungssignal gebildet und als der Kontrollwert erachtet werden, und/oder die Summe aus dem unverzögerten Signal und dem zweiten Verzögerungssignal gebildet und als der Kontrollwert erachtet werden, und die Differenz aus dem ersten und dem zweiten Verzögerungssignal gebildet und als zusätzlicher hoher Kontrollwert erachtet werden, und/oder die Summe aus dem ersten und dem zweiten Verzögerungssignal gebildet und als zusätzlicher hoher Kontrollwert erachtet werden, und die Differenz aus dem unverzögerten Signal und dem dritten Verzögerungssignal gebildet und als zusätzlicher niedriger Kontrollwert erachtet werden, und/oder die Summe aus dem unverzögerten Signal und dem dritten Verzögerungssignal gebildet und als zusätzlicher niedriger Kontrollwert erachtet werden. Von dem Verhältnis des hohen und des niedrigen Kontrollwertes kann dann darauf geschlossen werden, ob die Mischfrequenz bzw. Trägerfrequenz vergrößert oder verkleinert werden muss. Bevorzugt bedingen das erste und das dritte Verzögerungselement jeweils eine beliebige vorgegebene Verzögerung, und/oder das erste und das zweite Verzögerungselement zusammengenommen diejenige Verzögerung, die dem reziproken Wert der vorgegebenen Frequenz oder einem Vielfachen des reziproken Wertes der vorgegebenen Frequenz entspricht.

Das erfindungsgemäße System zum Abgleichen einer Mischfrequenz eines Mischers und einer Trägerfrequenz eines von dem Empfänger empfangenen Signals kann in Weiterbildung entsprechend ausgebildet und/oder eingerichtet sein.

Dann kann, wie vorstehend bereits im Zusammenhang mit der analogen bevorzugten Ausführungsform des Verfahrens zum Abgleichen der einer Empfänger- und Sender-Clockfrequenz erläutert, eine gezielte Frequenzanpassung, vorliegend der Mischfrequenz, erfolgen. Hier gilt dann zweckmäßiger Weise, dass für den Fall, dass das Verhältnis des niedrigen zum hohen Kontrollwert größer 1 ist, also der niedrige Kontrollwert größer als der hohe Kontrollwert ist, die Mischfrequenz gesenkt oder die Trägerfrequenz erhöht wird. Für den Fall, dass das Verhältnis des niedrigen zum hohen Kontrollwert kleiner 1 ist, also der niedrige Kontrollwert kleiner als der hohe Kontrollwert ist, wird zweckmäßiger Weise die Mischfrequenz erhöht oder die Trägerfrequenz gesenkt. Sind der hohe und der niedrige Kontrollwert gleich groß, erfolgt bevorzugt keine Anpassung der Misch- und/oder Trägerfrequenz. Dies wird in der Regel nur der Fall sein, wenn das Kontrollsignal (zufällig) bereits den minimalen Wert hat und entsprechend die Frequenzkomponente des Ausgangssignals des Frequenzabgleich-Mischers in einem festen, bevorzug ganzzahligen Verhältnis zu der Mischfrequenz steht, insbesondere eine Harmonische oder Subharmonische der Mischfrequenz ist. Das erfindungsgemäße System, insbesondere eine Auswerte- und Steuereinheit dieses, ist bevorzugt entsprechend ausgebildet und/oder eingerichtet, insbesondere, um Steuersignale für entsprechende Anpassungen auszugeben.

Es hat sich gezeigt, dass für den Fall, dass ein Trainingssignal, das nicht moduliert ist, also nur eine Trägerfrequenz ohne Modulation gesendet wird, direkt die Offsetfrequenz ohne das vorherige Heruntermischen mit dem Frequenzabgleich-Mischer abgeglichen werden kann.

Dies wird im Rahmen des Verfahrens zur Positionsbestimmung genutzt. Dieses zeichnet sich entsprechend dadurch aus, dass die von den Sendern gesendeten Signale, bevor sie mit der Empfänger-Clockfrequenz abgetastet werden, einem Mischer, insbesondere einer Gilbertzelle, zugeführt werden, in der sie mit einer Mischfrequenz gemischt, insbesondere runtergemischt werden, und die Mischfrequenz dieses Mischers vor der Positionsbestimmung wenigstens ein Mal unter Durchführung des erfindungsgemäßen Verfahrens zum Abgleichen der Mischfrequenz eines Mischers eines Empfängers und der Trägerfrequenz mit einer Trägerfrequenz des von einem der Sender stammenden Signal abgeglichen wird..

Für den Abgleich der Sender- und Empfänger-Clockfrequenz und für den Abgleich der Trägerfrequenz vom Trainingssignal und der Mischfrequenz kann dasselbe bzw. können dieselben Verzögerungselemente genutzt werden. Es kann insbesondere dasselbe System zum Einsatz kommen, welches solche umfasst. Mit anderen Worten kann gelten, dass ein System, das zur Durchführung des Verfahrens zum Abgleich der Sender- und Empfänger-Clockfrequenz ausgebildet und/oder eingerichtet ist, auch zur Durchführung des erfindungsgemäßen Verfahrens zum Abgleichen der Mischfrequenz eines Mischers eines Empfängers und der Trägerfrequenz eines von dem Empfänger empfangenen Signals ausgebildet und/oder eingerichtet ist. Der Frequenzabgleich-Mischer - und ggf. weitere Komponenten - können dann beispielsweise überbrückt werden, das Signal also an diesem vorbei dem oder den Verzögerungselementen zugeführt werden.

Die Positionsbestimmung erfolgt im Rahmen des erfindungsgemäßen Verfahrens für diese bevorzugt, indem der Empfänger das jeweilige Signal mit der von der Sender-Clockfrequenz verschieden Empfänger-Clockfrequenz oder mit einer Frequenz, die oder in einem festen, bevorzug ganzzahligen Verhältnis zu der Empfänger-Clockfrequenz steht, insbesondere eine Harmonische oder Subharmonische der Empfänger-Clockfrequenz ist abtastet, um eine virtuelle Überabtastung der Signale zu realisieren, und die Ankunftszeiten der von den Sendern gesendeten Signale bei dem Empfänger bestimmt werden, und aus den Ankunftszeiten die Position des Empfängers relativ zu den Sendern ermittelt wird.

Das Signal des jeweiligen Senders wird von dem Empfänger besonders bevorzugt derart abgetastet, dass aus mehreren hintereinanderliegenden, bevorzugt 64 aufeinanderfolgenden Signalperioden, deren Dauer insbesondere jeweils dem reziproken Wert der Sender-Clockfrequenz entspricht, Abtastwerte erhalten werden, wobei durch die Abtastung mit der von der Sender-Clockfrequenz verschiedenen Frequenz Abtastwerte erhalten werden, die an verschiedenen Positionen innerhalb der Signalperioden liegen, und dass die aus den verschiedenen Signalperioden stammenden Abtastwerte zusammengesetzt werden, und aus dem Ergebnis die Ankunftszeit des von dem jeweiligen Sender gesendeten Signals bei dem Empfänger bestimmt wird.

Die Signalperioden können auch als Chips erachtet und bezeichnet werden, wie es aus dem Bereich konventioneller Systeme und Verfahren zur Positionsbestimmung, etwa Indoor-Positionsbestimmung, bekannt ist. Mehrere aufeinanderfolgende Signalperioden bzw. Chips können auch als Sequenz bzw. Signal- oder Chipsequenz bezeichnet werden.

Innerhalb jeder Signalperiode bzw. innerhalb jedes Chips können beispielsweise vier in der ersten Hälfte der Signalperiode bzw. des Chips liegende Abtastwerte bestimmt werden. Andere Anzahlen von Abtastwerten je Flanke sind natürlich ebenfalls möglich. Die Anzahl kann im Einzelfall mit Hinblick auf die Abtastrate und die Flankensteilheit geeignet gewählt werden.

Weiterhin kann vorgesehen sein, dass zunächst eine Grobbestimmung des Nulldurchgangs am Anfang der jeweiligen Periode erfolgt. Dies bedeutet insbesondere oder schließt insbesondere mit ein, dass die Flanke ohne eine virtuelle Überabtastung bestimmt wird, im vorstehend beispielhaft genannten Fall mit 64 für die Überabtastung berücksichtigten Flanken also mit einer 64 mal größeren Ungenauigkeit. Dies ist insbesondere vorteilhaft, um die Abtastwerte zu bestimmen, die die Flanke beschreiben.

Das System zur Positionsbestimmung kann sich in weiterer vorteilhafter Ausgestaltung ferner dadurch auszeichnen, dass der oder wenigstens einer der Empfänger eine Kanalauswahleinheit aufweist, die wenigstens einen, bevorzugt mehrere Mischer, Kanal-Auswahlmischer, und wenigstens einen Filter umfasst, insbesondere, wobei der oder die Kanal-Auswahlmischer als digitale Mischer ausgebildet sind, bevorzugt, wobei der oder die Kanalauswahl-Mischer jeweils wenigstens eine Schaltung umfassen, die eine CORDIC-Algorithmus realisieren, oder durch wenigstens eine solche Schaltung gegeben sind. Die Abkürzung CORDIC steht dabei in bekannter Weise für COordinate Rotation Digital Computer. So kann eine Frequenzumsetzung mit einer hohen Genauigkeit bei vergleichsweise geringem Aufwand, insbesondere vergleichsweise geringem Platz- und Leistungsaufwand, realisiert werden. Eine Multiplikation ist ebenfalls denkbar, diese ist jedoch in der Regel mit deutlich mehr Platz- und Leistungsaufwand verbunden.

Die Kanalauswahleinheit ist zweckmäßiger Weise dem Frequenz-Abgleichmischer vorgeschaltet. Dann ist insbesondere der Ausgang der Kanalauswahleinheit mit dem Eingang des Frequenz-Abgleichmischers gekoppelt.

Weiterhin kann vorgesehen sein, dass der oder wenigstens einer der Empfänger eine Empfangseinheit aufweist, die einen Mischer, der insbesondere wenigstens eine Gilbertzelle umfasst oder durch wenigstens eine Gilbertzelle gegeben ist, und einen A/D-Wandler umfasst. Die Empfangseinheit ist zweckmäßiger Weise dem Frequenzabgleich-Mischer und, wenn vorhanden, der Kanalauswahleinheit vorgeschaltet. Dann ist insbesondere der Ausgang der Empfangseinheit mit dem Eingang der Kanalauswahleinheit gekoppelt und der Ausgang der Kanalauswahleinheit mit dem Eingang des Frequenzabgleich-Mischers.

Der Ausgang der Empfangseinheit kann dann mit dem Eingang des oder im Falle mehrerer des ersten der Verzögerungselemente gekoppelt oder koppelbar sein. Dies ermöglicht es insbesondere, dass ein von einem Sender gesendetes Trainingssignal ohne Modulation genutzt wird, um die Clock-Offsetfrequenz ohne das Heruntermischen in dem Frequenzabgleich-Mischer direkt abzugleichen. Der Frequenz-Abgleichmischer und gegebenenfalls vorhandene weitere Komponenten, etwa eine ggf. vorhandene Kanalauswahleinheit können dann mit anderen Worten "überbrückt" werden und es ist möglich, das Trainingssignal nach einem Heruntermischen in einem insbesondere analogen Mischer, das bevorzugt dem Erhalt eines gut A/D-wandelbaren Signales dient, direkt dem oder dem ersten Verzögerungselement zugeführt werden.

Das erfindungsgemäße System zur Positionsbestimmung ist zur Durchführung des erfindungsgemäßen Verfahrens zum Abgleichen der Mischfrequenz eines Mischers eines Empfängers und der Trägerfrequenz eines von dem Empfänger empfangenen Signals ausgebildet und/oder eingerichtet . Es können insbesondere, wie vorstehend dargelegt, für den Abgleich der Sender- und Empfänger-Clockfrequenz und für den Abgleich von Mischfrequenz und Trägerfrequenz dasselbe wenigstens eine Verzögerungselement genutzt werden.

Sämtliche Einheiten können sowohl in Hardware als auch in Software als auch in einer Kombination aus Hardware und Software implementiert sein. Hinsichtlich der Ausgestaltungen der Erfindung wird auch auf die Unteransprüche sowie auf die nachfolgende Beschreibung mehrerer Ausführungsbeispiele unter Bezugnahme auf die beiliegende Zeichnung verwiesen.

In der Zeichnung zeigt:
Figur 1 eine rein schematische Darstellung eines Ausführungsbeispiels eines erfindungsgemäßen Systems zur Indoor-Positionsbestimmung;
Figur 2 einige Komponenten eines Empfängers des Systems aus Figur 1 in vergrößerter, rein schematischer Darstellung;
Figur 3 die von mehreren Sendern des Systems aus Figur 1 stammenden, von dem Empfänger empfangenen Signale sowie deren Weiterverarbeitung in Frequenzdarstellung;
Figur 4 eine Signalsequenz in rein schematischer Darstellung;
Figur 5 eine rein schematische Darstellung zur virtuellen Überabtastung der Signalsequenz aus Figur 4; und
Figur 6 eine rein schematische Darstellung zu Ankunftszeiten der Signale der Sender des Systems aus Figur 1 beim Empfänger.

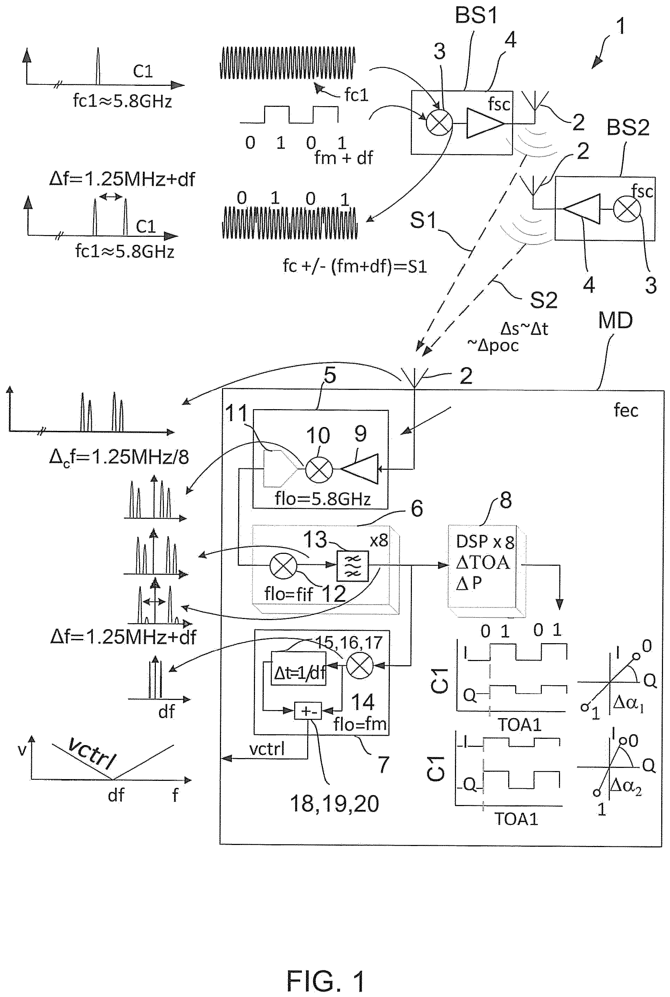

Die Figur 1 zeigt in rein schematischer Darstellung ein Ausführungsbeispiel eines erfindungsgemäßen Indoor-Positionierungssystems 1. Das System umfasst acht jeweils einen Sender bildende Basisstationen BS1-BS8, von denen in der Figur nur zwei beispielhaft gezeigt sind, und ein einen Empfänger bildendes Mobilgerät MD, dessen Position im Raum zu bestimmen ist.

Die Basisstationen BS1-BS8 und das Mobilgerät MD bilden Bestandteile eines digitalen Sende- und Empfangszuges.

Die acht Basisstationen BS1-BS8 sind auf die acht Ecken eines nicht weiter gezeigten Raumes verteilt und dort jeweils ortsfest angeordnet. Konkret ist in bzw. nahe jeder Ecke eine der Basisstationen BS1-BS8 vorgesehen. Es sei betont, dass sich die Anzahl von acht Basisstationen BS1-BS2 insbesondere für einen quaderförmigen Raum besonders bewährt hat, diese Anzahl jedoch keineswegs zwingend ist. Vielmehr kann ein erfindungsgemäßes System prinzipiell auch weniger oder mehr als acht Basisstationen BS1-BS8 umfassen. Weiterhin sei betont, dass, auch wenn nur ein Mobilgerät MD beispielhaft gezeigt ist, das System natürlich auch mehrere solche umfassen kann. Der Aufbau und zugehörige Ablauf wird im Folgenden beispielhaft anhand des einen Mobilgerätes MD beschrieben.

Die Basisstationen BS1-BS8 senden im Betrieb jeweils ein Signal S1-S8 aus. Die Signale S1-S8 aller Basisstationen BS1-BS8 werden von dem Mobilgerät MD empfangen. Die Signalübertragung ist dabei kabellos. Entsprechend weist jede Basisstation BS1-BS8 und auch das Mobilgerät MD jeweils eine Antenne 2 auf.

Die von den Basisstationen BS1-BS8 gesendeten Signale S1-S8 zeichnen sich jeweils durch eine Trägerfrequenz fc1-fc8 und eine Modulationsfrequenz fm+df aus. Die Trägerfrequenzen aller Basisstationen BS1-BS8 unterscheiden sich. Die Modulationsfrequenz fm+df hingegen ist für alle Basisstationen BS1-BS8 gleich. Die Trägerfrequenzen fc1-fc8 können auch als Kanalfrequenzen bezeichnet werden. Dies davon ausgehend, dass zu jedem Sender, also jeder Basisstation BS1-BS8, ein Kanal gehört.

Jede der Basisstationen BS1-BS8 umfasst in an sich bekannter Weise einen Quarzoszillator und einen Frequenzgenerator, mit dem aus der Frequenz des Quarzoszillators die Sender-Clockfrequenz generiert wird. Dies gilt gleichermaßen für das Mobilgerät MD, wobei mit dessen Frequenzgenerator die Empfänger-Clockfrequenz aus der Frequenz deren Quarzoszillators erzeugt wird. Der jeweilige Frequenzgenerator erzeugt ein Signal mit einer Frequenz, das in einem festen Verhältnis zur Frequenz des jeweiligen Quarzoszillators steht (Frequenzumsetzungsfaktor). Dieser Frequenzumsetzungsfaktor kann hochgenau eingestellt werden.

In der Figur 1 oben links ist - rein schematisch - die Trägerfrequenz fc1 der ersten Basisstation BS1 in einem Graphen in der Frequenzdarstellung und rechts daneben das Signal über der Zeit gezeigt. Wie man erkennt, handelt es sich um eine sinusförmige Schwingung mit entsprechender Frequenz. Die Trägerfrequenz fc1 der ersten Basisstation BS1 beträgt etwa 5,8 GHz, wobei dies rein beispielhaft zu verstehen ist. Unterhalb der sinusförmigen Trägerfrequenz fc1 ist die Modulation schematisch dargestellt. Konkret wird mit der Modulationsfrequenz fm+df die Phase um 180° geändert. Das resultierende Signal S1, also das ein sinusförmige Trägersignal mit der Trägerfrequenz fc1, dessen Phase sich mit der Modulationsfrequenz fm+df ändert, konkret jeweils um 180°, ist darunter gezeigt. Links davon findet sich wieder die zugehörige Frequenzdarstellung. Die Modulationsfrequenz beträgt 1,25 MHz zuzüglich einer Überabtastfrequenz df, auf die weiter unten noch näher eingegangen wird, also 1,25 MHz + df, was in dem Graphen mit der Frequenzdarstellung eingetragen ist. Es findet sich um die Trägerfrequenz fc1 ein Peak im Abstand von -1,25 MHz + df und ein weiterer Peak im Abstand von 1,25 MHz + df.

Die Modulationsfrequenz fm+df entspricht einer Harmonischen oder Subharmonischen der für alle Basisstationen BS1-BS8 gleichen Sender-Clockfrequenz fsc.

Das Signal wird in einem Mischer 3 der jeweiligen Basisstation BS1-BS8 erhalten. Der Mischer 3 umfasst vorliegend eine logische Verknüpfung, mit der man mit einem Eingangssignal eine Invertierung eines zweiten Eingangssignals am Ausgang der Verknüpfung bewirken kann. Diese logische Verknüpfung kann beispielsweise durch ein XNOR-Glied geschehen bzw. implementiert sein. Die Abkürzung XNOR steht dabei in bekannter Weise für den englischen Ausdruck "eXclusive Not OR". Es soll erreicht werden, dass das Vorzeichen des einen Signals mit dem Vorzeichen des anderen Signals verändert wird. Jede Basisstation BS1-BS8 umfasst ferner einen Leistungsverstärker 4.

Es gilt: Länge der Sendestrecke Δs ist proportional zu der Zeit Δt, in der die Welle die Strecke zurücklegt, und diese ist proportional zur Phase der Frequenz Δpoc, wobei die Abkürzung poc für phase of carrier steht.

Die Signale S1-S8 aller Basisstationen BS1-BS8 werden im Betrieb von dem Mobilgerät MD empfangen und mit der Empfänger-Clockfrequenz fec be- bzw. verarbeitet. Aus den Ankunftszeiten TOA der Signale S1-S8 bei dem Mobilgerät MD kann in an sich vorbekannter Weise die Position von MD im Raum bestimmt werden.

Eine besonders hohe Ortsauflösung von beispielsweise 1mm wäre für die Positionsbestimmung sehr erstrebenswert. Die Ankunftszeit (englisch: Time of Arrival, kurz ToA) des (jeweiligen) Empfangssignales ist dann mit einer Auflösung im Pikosekunden-Bereich zu bestimmen. Würde man die die Clockfrequenzen entsprechend wählen, würde ein sehr hoher Stromverbrauch anfallen.

Eine deutlich energieeffizientere Lösung, die gleichzeitig eine Zeitauflösung im Pikosekunden-Bereich und somit sehr gute Ortsauflösung bietet, besteht darin, die Clockfrequenzen nicht zu erhöhen, sondern eine virtuelle Überabtastung zu realisieren. Hierfür arbeiten Sender BS1-BS8 und Empfänger MD mit Clocks, die einen sehr kleinen aber genauen Frequenzunterschied haben. Dieser kann beispielsweise im Bereich von 1 Hz liegen. Man kann auch von inkommensurablen Clockfrequenzen sprechen. Die Clockfrequenz des Mobilgerätes MD, also die Sender-Clockfrequenz, wird vorliegend als fsc bezeichnet und der Frequenzunterschied zwischen Sender- und Empfänger-clockfrequenz fsc, fec als Clock-Offsetfrequenz df.

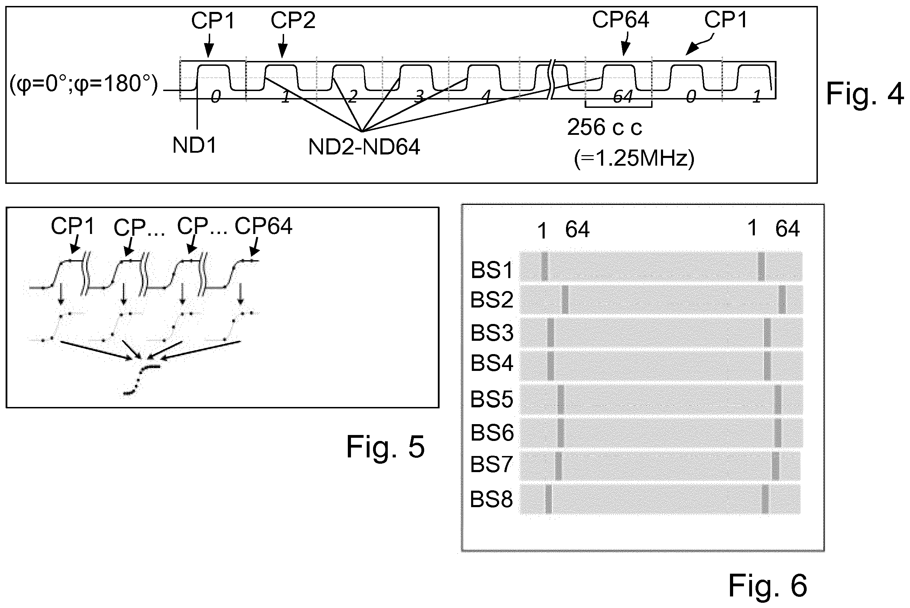

Bei einem konventionellen Positionierungssystem besteht das Sendesignal in der Regel aus einer festen Symbolfolge, einem sogenannten Chip. Dieser Chip wird immer wiederholt und bei den konventionellen Systemen die Phase des Chipsignales zur Ankunftszeitbestimmung genutzt. Für die virtuelle Überabtastung wird eine Anzahl aufeinanderfolgender Chips, die vorliegend auch als Sequenz bzw. Signalsequenz bezeichnet wird, genutzt. In der Figur 4 ist rein schematisch und beispielhaft eine Sequenz mit 64 Chips CP1-CP64 dargestellt. Aufgrund des Frequenzunterschiedes zwischen der Sender-Clockfrequenz fsc und der Empfänger-Clockfrequenz fec, also aufgrund des df "driften" die Abtastpunkte (englisch: sampling points) in jedem Chip bzw. Zyklus. Dann können die Abtastpunkte aus mehreren aufeinanderfolgenden Chips bzw. Zyklen CP1-CP64 für die Rekonstruktion einer Flanke mit sehr hoher Auflösung herangezogen werden, wie es rein schematisch in Figur 5 dargestellt ist.

Der Frequenzunterschied zwischen Sender- und Empfänger-Clockfrequenz fsc, fec, also die Clock-Offsetfrequenz df, wird für die Überabtastung gezielt so gewählt, dass Sender- und Empfänger-Clock fsc, fec nach einer Signalsequenz wieder gleich sind, also insbesondere eine gemeinsame subharmonische Frequenz besitzen. Der Frequenzunterschied df kann beispielsweise für eine Empfänger-Clockfrequenz fec von 1,25 MHz bei z.B. ca. 1,19 Hz liegen. Gewünschte bzw. geeignete Werte der Sender- und Empfänger-Clockfrequenz fsc, fec und somit auch die Clock-Offsetfrequenz df, werden zweckmäßiger Weise vorab festgelegt. Daraus ergibt sich auch, welche Chipanzahl für die Überabtastung herangezogen wird. In der Figur 4 ist rein schematisch und beispielhaft eine Sequenz mit 64 Chips CP1-CP64 dargestellt.

Eine mögliche Fehlerquelle in einem digitalen Empfangszug liegt in einer nicht abgeglichenen Clockfrequenz des Senders und Empfängers. Bei inkommensurablen Clockfrequenzen ist ein genauer Abgleich dieser Frequenzen mit aus dem Stand der Technik vorbekannten Methoden nicht möglich, da die Phase der beiden Clockfrequenzen nicht gleich ist, sondern sich zyklisch zueinander verändert.

Es wird ein Abgleich möglich. Hierfür ist das in Figur 1 dargestellte System 1, konkret das Mobilgerät MD dieses dazu ausgebildet und eingerichtet, ein Ausführungsbeispiel eines Verfahrens zum Abgleichen der Sender-Clockfrequenz fsc eines ein Signal sendenden Senders BS1-BS8 und der Empfänger-Clockfrequenz fec eines das Signal empfangenden Empfängers MD durchzuführen.

Das Mobilgerät MD umfasst eine Empfangseinheit 5, eine Kanalauswahleinheit 6 und eine Frequenzabgleichseinheit 7, die ein Ausführungsbeispiel eines erfindungsgemäßen Systems zum Abgleich von Sender- und Empfänger-Clockfrequenz fsc, fec bildet. Es weist ferner eine Einheit 8 zur Bestimmung der jeweiligen Time of Arrival TOA der Signale, also insbesondere des Startpunktes der Chips (Eins Null Durchgang), und der Phase der Trägerfrequenz, auf. Der zugehörige Ablauf ist rein schematisch unterhalb des Blockes dargestellt. Es sind in zwei schematische, dimensionslose Graphen beispielhaft für die Basisstationen BS1 und BS2 gezeigt, in denen mehrere Chips exemplarisch dargestellt sind. Wie man sieht, liegt die Ankunftszeit TOA1 der Flanke des Signals von BS1 bei MD für das gezeigte Beispiel später als die Ankunftszeit TOA2 der Flanke des Signals von BS2 bei MD. Dies Ankunftszeiten können insbesondere für eine Grobbestimmung der Position von MD genutzt werden. Wie man ferner sieht, gilt für C1, dass I > Q ist und für C2, dass I < Q ist. Das Verhältnis von I/Q entspricht einem Winkel im I/Q-Diagramm, welches jeweils neben dem Graphen von C1 und C2 rein schematisch dargestellt ist. Die Phase kann zur Feinbestimmung der Position genutzt werden.

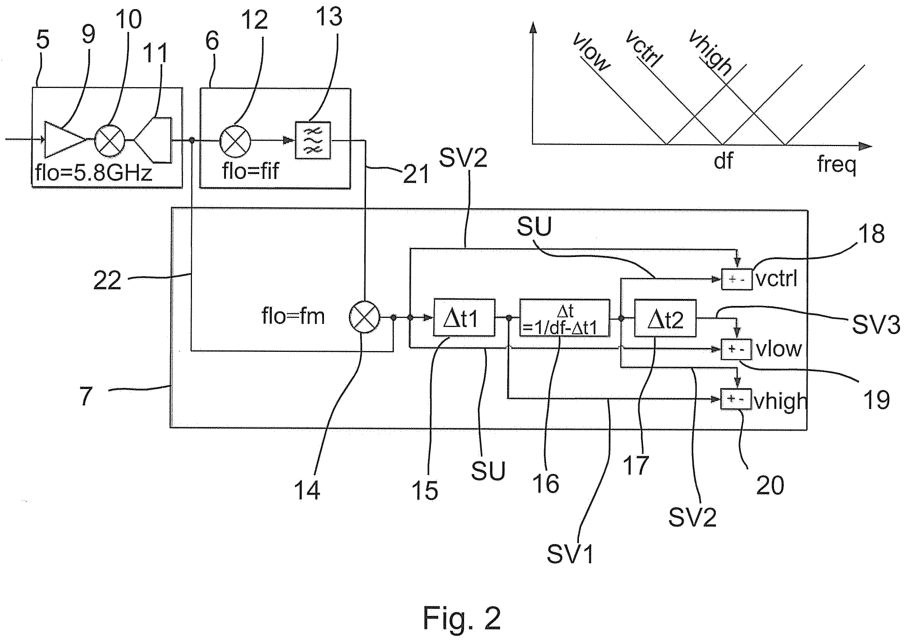

Die Empfangseinheit 5, Kanalauswahleinheit 6 und Frequenzabgleichseinheit 7 können auch der Figur 2 entnommen werden, die eine vergrößerte Darstellung einiger Komponenten des Mobilgerätes MD aus Figur 1 zeigt. Die Einheit 8 ist in der Figur 2 nicht zusätzlich dargestellt, kann aber der Figur 1 entnommen werden.

Die Empfangseinheit 5 umfasst einen rauscharmen Vorverstärker 9, einen analogen Mischer 10, der bei dem dargestellten Beispiel durch eine Gilbertzelle gegeben ist oder eine solche umfasst, und zur Abgrenzung gegenüber weiteren Mischern vorliegend als Empfangsmischer 10 bezeichnet wird, und einen Analog/Digital-Wandler 11, mittels dem im Betrieb eine Abtastung empfangener Signale mit einer Frequenz, die der der Empfänger-Clockfrequenz fec entspricht oder in einem festen, bevorzug ganzzahligen Verhältnis zu der Empfänger-Clockfrequenz fec steht, insbesondere eine Harmonische oder Subharmonische der Empfänger-Clockfrequenz fec ist, erfolgen kann bzw. erfolgt. Die Mischfrequenz des Empfangsmischers 10 ist in der Figur als flo=5.8 GHz eingetragen.

Die Kanalauswahleinheit 6 umfasst mehrere digitale Mischer 12, die vorliegend - zur Abgrenzung gegenüber dem Mischer 10 aus Einheit 5 - als Kanalauswahlmischer 12 bezeichnet werden. Von den Kanalauswahlmischern 12 sind insgesamt acht Stück vorgesehen, für jeden der acht zu den acht Basisstationen BS1-BS8 gehörigen Kanäle C1-C8 einer. Die weiteren sieben Kanalauswahlmischer 12 sind zu dem einen, in den Figuren 1 und 2 gezeigte Kanalauswahlmischer 12 parallel geschaltet. In der schematischen Figur 2 ist beispielhaft nur einer der acht Kanalauswahlmischer 12 gezeigt. Den Kanalauswahlmischern 12 nachgeschaltet ist ein Filterelement 13, welches wenigstens einen Filter, konkret wenigstens einen digitalen Kammfilter, umfasst bzw. als solcher ausgebildet ist. Die Kanalauswahlmischer 12 können jeweils durch einen CORDIC bzw. eine zugehörige Schaltung implementiert sein, so dass platzsparend und leistungsarm das Signal gemischt werden kann.

Die Frequenzabgleichseinheit 7 des Mobilgerätes MD umfasst einen Mischer 14, der zur Abgrenzung gegenüber den weiteren Mischern 10, 12 der Einheiten 5, 6 als Frequenzabgleich-Mischer 14 bezeichnet wird. Auch der Frequenzabgleichs-Mischer 14 kann durch einen CORDIC bzw. eine zugehörige Schaltung implementiert sein, so dass besonders platzsparend und leistungsarm das Signal gemischt werden kann.

Der Frequenzabgleich-Mischer 14 ist derart ausgebildet und/oder eingerichtet, dass in diesem ein Mischen, insbesondere Heruntermischen mit einer Mischfrequenz flo=fm erfolgen kann, die der Empfänger-Clockfrequenz fec entspricht oder in einem festen, bevorzugt ganzzahligen Verhältnis zu der Empfänger-Clockfrequenz fec steht, insbesondere eine Harmonische oder Subharmonische der Empfänger-Clockfrequenz fec ist. So kann ein Ausgangssignal erhalten werden, das eine Frequenzkomponente enthält, die der aktuellen Differenz df zwischen der Sender-Clockfrequenz fsc und der Empfänger-Clockfrequenz fec entspricht. Vorliegend entspricht die Mischfrequenz dieses Mischer der Modulationsfrequenz fm+df des Senders abzüglich der Frequenzdifferenz df, also fm.

Der Ausgang der Kanalauswahleinheit 6 ist mit dem Eingang des Frequenzabgleich-Mischers 14 über eine Leitung 21 verbunden. Es ist ferner eine Überbrückungsleitung 22 vorgesehen, über welche der Ausgang der Empfangseinheit 5 mit dem Eingang des ersten Verzögerungselementes 15 verbindbar ist. Diese Leitung 22 kann bei Bedarf geöffnet werden, um das Signal bei Bedarf entsprechend umzuleiten.

Es sei betont, dass die Bezeichnungen "Empfangs-", "Kanalauswahl-"und " Frequenzabgleichs-"keine Funktionsangaben für die Mischer 10, 12, 14 darstellen, sondern nur für der Unterscheidung dienen. Es handelt sich bei diesen Komponenten jeweils um herkömmliche, konventionelle digitale bzw. analoge Mischer.

Die Frequenzabgleichseinheit 7 umfasst ferner drei Verzögerungselemente 15, 16, 17, und drei Additions- und Subtraktionselemente 18, 19, 20. Die Verzögerungselemente 15, 16, 17 umfassen bei dem dargestellten Ausführungsbeispiel Flipflops bzw. sind durch solche gegeben. Die Additions- und Subtraktionselemente 18, 19, 20 sind vorliegend digital ausgebildet, konkret als AND-Glied mit Carry over, wobei auch dies rein beispielhaft zu verstehen ist.

Es sei angemerkt, dass in der schematischen Figur 1 nur ein Verzögerungselement und ein Additions- und Subtraktionselement beispielhaft gezeigt sind und je alle drei Elemente nur der vergrößerten Darstellung aus Figur 2 entnommen werden können.

Das erste Verzögerungselement 15 bedingt, insbesondere im eingeschwungenen Zustand, eine vorgegebene Verzögerung Δt1. Diese kann beispielsweise 256/df betragen. Da zweite Verzögerungselement 16 bedingt, insbesondere im eingeschwungenen Zustand eine Verzögerung, Δt, die der Differenz aus dem reziproken Wert der vorgegebenen Clock-Offsetfrequenz df und der Verzögerung des ersten Verzögerungselementes 15 entspricht. Mit anderen Worten gilt Δt = 1/df -Δt1. Das dritte Verzögerungselement 17 bedingt, in Analogie zu dem ersten, insbesondere im eingeschwungenen Zustand, eine vorgegebene Verzögerung Δt2, die beispielsweise 256/df betragen kann.

Die Anordnung ist derart getroffen, dass das Ausgangssignal des Frequenzabgleich-Mischers 14 einerseits nacheinander durch alle drei Verzögerungselemente 15, 16, 17 geführt und andererseits an den Verzögerungselementen 15, 16, 17 vorbeigeführt werden kann, um ein unverzögertes Signal SU zu erhalten. Es wird, wie man der Figur 2 entnehmen kann, hinter jedem der drei Verzögerungselemente 15, 16, 17 jeweils das Signal abgegriffen. Das bedeutet, das Ausgangssignal des Frequenzabgleich-Mischers 14 wird mit dem ersten Verzögerungselement 15 verzögert, wodurch eine erstes Verzögerungssignal SV1 erhalten wird, und das Ausgangssignal des Frequenzabgleich-Mischers 14 wird mit dem ersten und dem zweiten Verzögerungselement 15 ,16 verzögert, wodurch ein zweites Verzögerungssignal SV2 erhalten wird, und das Ausgangssignal des Frequenzabgleich-Mischers 14 wird mit dem ersten und dem zweiten und dem dritten Verzögerungselement 15, 16, 17 verzögert, wodurch ein drittes Verzögerungssignal SV3 erhalten wird. Mittels der drei Additions- und Subtraktionselemente 18, 19, 20 können dann drei verschiedene Differenzen gebildet werden, nämlich:
vctrl = SV2 -SU mit dem Verzögerungselement 18
vlow = SV3 - SU mit dem Verzögerungselement 19
vhigh = SV2 -SV1 mit dem Verzögerungselement 20.

Hierdurch werden der Abgleich und eine gezielte Einstellung möglich, worauf im Folgenden noch näher eingegangen wird.

Alternativ oder zusätzlich dazu, dass die drei vorstehenden Differenzen gebildet werden, ist es natürlich auch möglich, entsprechende Summen zu bilden.

Es sei angemerkt, dass bei dem hier beschriebenen Ausführungsbeispiel der Kontrollwert und die beiden zusätzlichen Kontrollwerte als Spannungssignale vorliegen, die insbesondere Ausgangssignale der Additions- und Subtraktionselemente 18, 19, 20 sind. Dies ist aber rein beispielhaft und nicht einschränkend zu verstehen.

Weiterhin sei angemerkt, dass die drei Additions- und Subtraktionselemente 18, 19, 20 Bestandteil einer nicht weiter dargestellten Auswerte- und Steuereinheit sind.

Ein Abgleich der Clockfrequenzen erfolgt zweckmäßiger Weise wenigstens ein Mal, bevor eine Positionsbestimmung durchgeführt wird, um besonders zuverlässige Werte zu erhalten.

Um den Abgleich durchzuführen, senden die Basisstationen BS1-BS8 ihre Signale, die sich jeweils durch eine Trägerfrequenz fc1-fc8 und die für alle gleiche Modulation mit der Modulationsfrequenz fm auszeichnen, die vorliegend einer Harmonischen oder Subharmonischen der Sender-Clockfrequenz fsc entspricht. Das Mobilgerät MD empfängt die Signale.

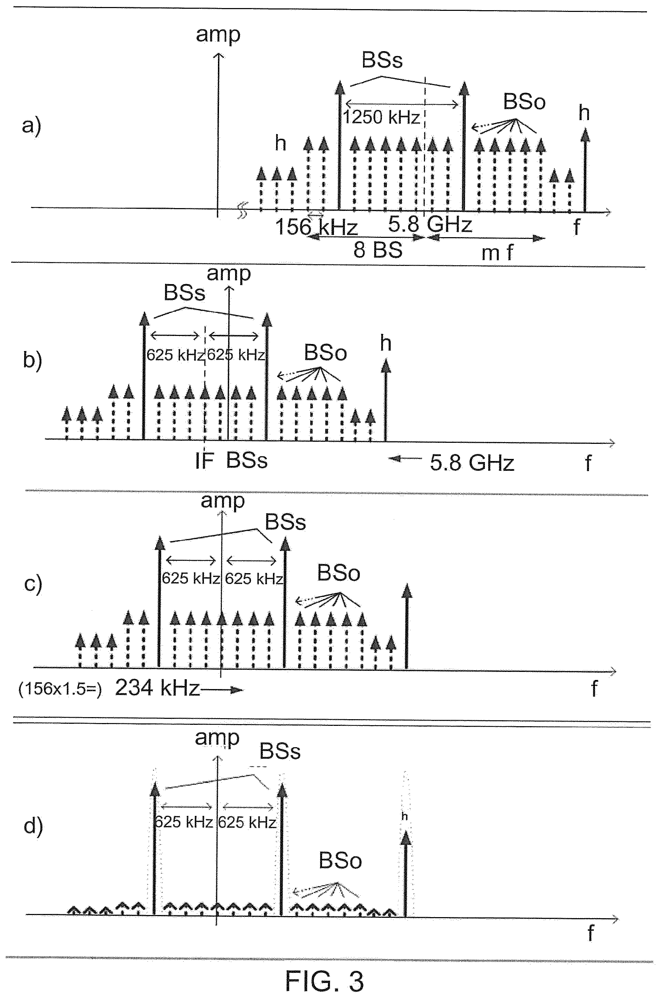

Die Figur 3 a) zeigt in vereinfachter Darstellung die Signale aller acht Basisstationen BS1-BS8 in der Frequenzdarstellung. Ein Pfeil soll hier jeweils eine Frequenzkomponente darstellen. Zu jedem Sender BS1-BS8 gehören zwei Pfeile, die um 1250 kHz voneinander beabstandet sind (vgl. auch die Figur 1). Ein entsprechendes Paar von Pfeilen ist hervorgehoben und mit BSs für die selektierte Basisstation bezeichnet. Die Pfeile der verbleibenden Basisstationen BS1-BS8 sind mit dem Bezugszeichen BSo versehen. Der Abstand zwischen zwei Pfeilen ist ebenfalls eingetragen, beträgt hier konkret 156 kHz. Dies ist der Frequenzabstand zwischen zwei Trägerfrequenzen fc1-fc8. Es sei angemerkt, dass auch unterschiedliche Abstände gewählt werden können, solange die Summe der Abstände kleiner als die Modulationsfrequenz ist, und sich somit die Frequenzspektren nicht überlagern.

Mittig der 16 Pfeile und somit Frequenzkomponenten aller Basisstationen BS1-BS8 liegt die Frequenz 5,8 GHz. Dies ist somit die zentrale Frequenz des Bandes. Zu beiden Seiten der insgesamt 16 Pfeile der Basisstation sind ferner Harmonische dargestellt, die mit dem Bezugszeichen h versehen sind.

Die Figur a) zeigt das Signal bzw. die Signale, wie sie von dem Mobilgerät MD empfangen werden. In der Empfangseinheit 5 erfolgt zunächst ein Heruntermischen in dem Mischer 10 mit der Mischfrequenz flo = 5.8 GHz, also der zentralen Frequenz des Bandes. Dies kann man auch als analoge Down-Conversion bezeichnen. Das Resultat ist in der Figur 3 b) dargestellt. In dem A/D-Wandler erfolgt die Abtastung mit der Empfänger-Clockfrequenz fec oder einer Frequenz, die in einem festen, bevorzug ganzzahligen Verhältnis zu der Empfänger-Clockfrequenz fec steht. Bei dem dargestellten Beispiel erfolgt die Abtastung mit einer Harmonischen oder Subharmonischen der Empfänger-Clockfrequenz fec.

In demjenigen Kanalauswahlmischer 12, der zu der ausgesuchten Basisstation BSs gehört, erfolgt dann ein Mischen mit der Mischfrequenz flo = fif. Dies ist eine Zwischenfrequenz, bei der es vorteilhafter Weise möglich ist, das Signal kanalunabhängig zu filtern und analog/digital zu wandeln. Vorliegend betragen die Zwischenfrequenzen für die acht Kanäle +312,5 kHz, -+312,5 kHz, + 250 kHz, -250kHz, +156,25 kHz, - 156,25 kHz, +78,125 kHz und -78,125 kHz, wobei dies wieder rein beispielhaft zu verstehen ist.

Das Resultat kann der Figur 3 c) entnommen werden. Die zu der ausgesuchten Basisstation BSs gehörigen Pfeile sind nun um Null zentriert.

In dem nachfolgenden Filterelement 13 werden mittels des digitalen Kammfilters die Signale der anderen, nicht ausgesuchten Basisstationen BSo unterdrückt, wodurch das in Figur 3 d) dargestellte Ergebnis erhalten wird.

Das Signal wird an die Frequenzabgleicheinheit 7 übergeben und dort mittels des Frequenzabgleich-Mischers 14 nochmals heruntergemischt, konkret mit der Mischfrequenz fm, die der Empfänger-Clockfrequenz fec entspricht oder in einem festen, bevorzugt ganzzahligen Verhältnis zu der Empfänger-Clockfrequenz fec steht, insbesondere eine Harmonische oder Subharmonische der Empfänger-Clockfrequenz fec ist. Für diesen Mischer 14 gilt also flo = fm. Hierdurch wird ein Signal erhalten, das eine Frequenzkomponente enthält, die der aktuellen Differenz zwischen der Sender-Clockfrequenz fsc und der Empfänger-Clockfrequenz fec entspricht. Anschließend wird ermittelt, ob die Frequenzkomponente des Ausgangssignals des Frequenzabgleich-Mischers 14 in einem festen, bevorzug ganzzahligen Verhältnis zu der Empfänger-Clockfrequenz fec steht, insbesondere eine Harmonische oder Subharmonische der Empfänger-Clockfrequenz fec ist.

Dies erfolgt bei dem dargestellten Beispiel, indem das Ausgangssignal des Frequenzabgleich-Mischers 14 einerseits den Verzögerungselementen 15, 16, 17 zugeführt wird, um das erste Verzögerungssignal SV1, das zweite Verzögerungssignal SV2 und das dritte Verzögerungssignal SV3 zu erhalten, und andererseits an den Verzögerungskomponenten 15, 16, 17 vorbeigeführt wird, um das unverzögerte Signal SU zu erhalten, und die vorgenannten Differenzen (und/oder Summen) zu ermitteln, die dann als der Kontrollwert vctrl, der zusätzliche hohe Kontrollwert vhigh und der zusätzliche niedrige Kontrollwert vlow erachtet werden.

Bei Bedarf wird die Empfänger-Clockfrequenz angepasst. Bedarf zur Anpassung besteht, wenn - im Falle der Differenzen - vctrl nicht den minimalen Wert aufweist bzw. im Falle der Summen nicht den maximalen. Denn dieser Wert ist dann im Falle der Differenzbildung minimal bzw. im Falle der Summenbildung maximal, wenn die Frequenzkomponente des Ausgangssignals des Frequenzabgleich-Mischers 14 in einem festen, bevorzug ganzzahligen Verhältnis zu der Empfänger-Clockfrequenz fec steht, insbesondere eine Harmonische oder Subharmonische der Empfänger-Clockfrequenz fec ist.

Ob vctrl den minimalen Wert aufweist, kann an vctrl alleine in der Regel nicht abgelesen werden. Man erhält immer einen Absolutwert und aufgrund von Rauschen kann der minimale Wert von Null verschieden sein bzw. ist immer von Null verschieden. Ob das Minimum vorliegt, kann natürlich dadurch ermittelt werden, dass die Empfänger-Clockfrequenz fec versuchsweise verändert wird, zweckmäßiger Weise in beide Richtungen, und abgelesen wird, ob bzw. in welche Richtung sich die Differenz verkleinert. Auch für den Fall der Summenbildung gibt der Kontrollwert vctrl alleine keine Auskunft und es kann bzw. müsste probiert werden.

Dank der zusätzlichen Kontrollwerte vhigh und vlow kann auf ein solches Probieren auch verzichtet werden. Denn es gilt, dass für den Fall, dass das Verhältnis des niedrigen zum hohen Kontrollwert, insbesondere vlow/vhigh größer 1, der niedrige Kontrollwert also größer als der hohe ist, die Empfänger-Clockfrequenz fec gesenkt werden muss, um das Minimum von vctrl zu erreichen. Ist hingegen der niedrige Kontrollwert vlow größer als der hohe Kontrollwert vhigh, muss die Empfänger-Clockfrequenz fec erhöht werden, um das Minimum von vctrl zu erreichen. Der Verlauf von vctrl, vhigh und vlow ist in der Figur 2 rechts oben - rein schematisch in einem Graphen ohne Skalierung - dargestellt.

Je nachdem, wie das Verhältnis von vhigh und vlow ist, wird also die Empfänger-Clockfrequenz fec erhöht oder gesenkt bzw. von der Auswerte- und Steuereinheit ein entsprechendes Steuersignal ausgegeben. Dieses Signal wird dazu benutzt, die Clockfrequenz zu verändern. Dies kann insbesondere durch ein Verändern des Frequenzumsetzungsverhältnisses in der Clocksynthese des Empfängers MD erreicht werden.

Wurde der minimale Wert von vctrl erzielt, ist der Abgleich erfolgreich durchgeführt. Wie man dem Graphen aus Figur 2 entnehmen kann, gilt beim Minimum von vctrl, dass vhigh und vlow gleich groß sind. Hieran könnte man somit auch erkennen, dass kein Bedarf an einer Anpassung der Empfänger-Clockfrequenz fec besteht, weil die vorgenannte Bedingung bereits erfüllt ist.

Der Vollständigkeit halber sei angemerkt, dass es natürlich auch möglich wäre, die Sender-Clockfrequenz fsc anzupassen, wobei hier ein Änderung in umgekehrte Richtungen erforderlich wäre.

Weiterhin sei angemerkt, dass es in der Regel ausreichend ist, den Abgleich mit dem Signal einer der Basisstationen BS1-BS8 wie vorstehend beschrieben durchzuführen und dann anzunehmen, dass die Sender-Clockfrequenz fsc der verbleibenden der Basisstationen BS1-BS8 gleich ist.

Es hat sich gezeigt, dass unter Nutzung eines Trainingssignals ohne Modulation ein Abgleich der Mischfrequenz des Mischers 10 der Empfangseinheit 5 ohne Heruntermischen in dem Frequenzabgleichs-Mischer 14 möglich ist.

Dafür wird - zweckmäßiger Weise von nur einer der Basisstationen BS1-BS8 - ein solches Trainingssignal gesendet, in der Empfangseinheit 5 genau wie vorstehend für die Signale mit Modulation beschrieben verarbeitet, dann jedoch über die Überbrückungsleitung 22, die hierfür gezielt aktiviert werden kann, den Verzögerungselementen 15, 16, 17 zugeführt.

Die Periode der Trägerfrequenz des Trainingssignals zeichnet sich dabei dadurch aus, dass deren Unterschied zu der Periode der Mischfrequenz des Mischers 10 derjenigen Verzögerung entspricht, die durch das erste und zweite Verzögerungselement 15, 16 zusammengenommen bedingt wird, also 1/df. Sie wird insbesondere explizit so gewählt bzw. eingestellt.

Es ist zweckmäßig, dass für diesen Abgleich nur eine der Basisstationen sendet, da die Kanalauswahleinheit 6 ebenfalls überbrückt wird.

Das Trainingssignal wird mit anderen Worten von dem Mobilgerät MD empfangen, in dem Mischer 10 mit Mischfrequenz heruntergemischt, im A/D-Wandler gewandelt und dann direkt den Verzögerungselementen 15, 16, 17 der Frequenzabgleichseinheit 7 zugeführt sowie daran vorbeigeführt. Es werden - in völliger Analogie zu dem vorstehen beschriebenen Ausführungsbeispiel des Verfahrens zum Abgleichen der Clockfrequenzen - ein erstes, zweites und drittes Verzögerungssignal SV1, SV2, SV3 und zusätzlich ein unverzögertes Signal SU erhalten und die gleichen Differenzen gebildet, um vctrl, vhigh und vlow zu erhalten.

Bei Bedarf wird dann die Mischfrequenz des Empfangsmischers 10 derart angepasst, dass die Differenz, also vctrl reduziert, insbesondere ein minimaler Wert hiervon erhalten wird. Von vhigh und vlow kann wieder abgelesen werden, ob eine Anpassung erforderlich ist und wenn ja, ob die Mischfrequenz des Empfangsmischers 10 vergrößert oder verkleinert werden muss. Konkret wird für den Fall, dass das Verhältnis des niedrigen zum hohen Kontrollwert größer 1 ist, also der niedrige Kontrollwert größer als der hohe Kontrollwert ist, die Mischfrequenz gesenkt. Es kann auch die Trägerfrequenz erhöht werden. Für den Fall, dass das Verhältnis des niedrigen zum hohen Kontrollwert kleiner 1 ist, also der niedrige Kontrollwert kleiner als der hohe Kontrollwert ist, wird zweckmäßiger Weise die Mischfrequenz erhöht oder die Trägerfrequenz gesenkt. Sind der hohe und der niedrige Kontrollwert gleich groß, erfolgt bevorzugt keine Anpassung der Misch- und/oder Trägerfrequenz. Dies wird in der Regel nur der Fall sein, wenn das Kontrollsignal (zufällig) bereits den minimalen Wert hat und entsprechend die Frequenzkomponente des Ausgangssignals des Frequenzabgleich-Mischers in einem festen, bevorzug ganzzahligen Verhältnis zu der Mischfrequenz steht, insbesondere eine Harmonische oder Subharmonische der Mischfrequenz ist. Das System, insbesondere die Auswerte- und Steuereinheit dieses ist bevorzugt entsprechend ausgebildet und/oder eingerichtet, insbesondere, um Steuersignale für entsprechende Anpassungen auszugeben.

Dies stellt ein Ausführungsbeispiel des erfindungsgemäßen Verfahrens zum Abgleichen der Mischfrequenz eines Mischers eines Empfängers und der Trägerfrequenz eines von dem Empfänger empfangenen Signals dar. Das erfindungsgemäße Positioniersystem mit der Einheit 7 mit der Leitung 22 ist dazu ausgebildet und eingerichtet.

Bevorzugt werden beide Abgleiche wenigsten ein Mal durchgeführt, bevor die eigentliche Positionsbestimmung erfolgt.

Für die Positionsbestimmung des Mobilgerätes MD empfängt dieses von allen Basisstationen BS1-BS8 Signale, die sich durch die jeweilige Trägerfrequenz fc1-fc8 und die Modulationsfrequenz auszeichnen.

Die Signale werden der Empfangseinheit 5, der Kanalauswahleinheit 6 und der Einheit 8 zugeführt.

Das Signal von der jeweiligen Basisstation BS1-BS8 wird von dem Empfänger derart abgetastet, dass aus mehreren hintereinanderliegenden, bevorzugt 64 aufeinanderfolgenden Chips CP1-CP64 bzw. Signalperioden, deren Dauer insbesondere jeweils dem reziproken Harmonischen Wert der Empfänger-Clockfrequenz entspricht, Abtastwerte erhalten werden, wobei durch die Abtastung mit der von der Sender-Clockfrequenz fsc verschiedenen Frequenz Abtastwerte erhalten werden, die an verschiedenen Positionen innerhalb der Chips CP1-CP64 bzw. Signalperioden liegen, wie es in den Figuren 4 und 5 rein schematisch dargestellt und vorstehend bereits erörtert wurde. Bei dem gezeigten Beispiel werden jeweils vier Abtastpunkte in jedem Chip CP1-CP64 erfasst.

Bevorzugt erfolgt zunächst eine Grobbestimmung des Zeitpunktes des Nulldurchgangs ND1 am Anfang des jeweiligen Chips CP1-CP64 bzw. der jeweiligen Periode und dann werden an den Nulldurchgängen ND2-ND64 der folgenden Chips CP2-CP64 Werte gesammelt.

Die aus den verschiedenen Chips CP1-CP64 Signalperioden stammenden Abtastwerte werden dann, wie ein Figur 5 schematisch dargestellt, zusammengesetzt, woraus eine virtuell überabgetasteter Chip bzw. eine virtuell überabgetastete Signalperiode resultiert, und diesem, insbesondere aus der Ankunftszeit und Phase dieses, wird die Ankunftszeit des von der jeweiligen Basisstation BS1-BS8 gesendeten Signals bei dem Mobilgerät MD bestimmt. Dies insbesondere mittels der Einheit 8 zur Bestimmung der jeweiligen Time of Arrival TOA der Signale, also insbesondere des Startpunktes der Chips (Eins Null Durchgang), und der Phase der Trägerfrequenz, wie vorstehend im Zusammenhang mit Figur 1 beschrieben. So wird eine sehr hohe Ortsauflösung bei gleichzeitig verhältnismäßig geringem Stromverbrauch möglich.

In der Figur 6 ist rein schematisch ein Beispiel verschiedener Ankunftszeiten der Signale von den acht Basisstationen BS1-BS8 gezeigt, die zur Positionsbestimmung genutzt werden können.

## Patentansprüche

1. Verfahren zum Abgleichen der Mischfrequenz eines Mischers (10) eines Empfängers (MD) und der Trägerfrequenz eines von dem Empfänger (MD) empfangenen Signals, bei dem
ein Signal von dem Empfänger (MD) bevorzugt kabellos empfangen wird, das eine Trägerfrequenz ohne Modulation aufweist, und das Signal in dem Mischer (10) mit einer Mischfrequenz gemischt, insbesondere heruntergemischt wird, und das erhaltene Ausgangsignal des Mischer (10) einerseits wenigstens einem Verzögerungselement (15, 16, 17), zugeführt wird, um wenigstens ein Verzögerungssignal (SV1-SV3) zu erhalten, und
das Ausgangssignal des Mischers (10) andererseits an dem wenigstens einen Verzögerungselement (15, 16, 17) vorbeigeführt wird, um zusätzlich ein unverzögertes Signal (SU) zu erhalten, und
die Differenz und/oder die Summe aus dem oder wenigstens einem der Verzögerungssignale (SV1-SV3) und dem unverzögerten Signal (SU) ermittelt und als Kontrollwert (vctrl) erachtet wird, und die Mischfrequenz des Mischers (10) bei Bedarf derart angepasst wird, dass die Differenz reduziert, insbesondere ein minimaler Wert dieser erhalten wird, und/oder dass die Summe erhöht, insbesondere ein maximaler Wert dieser erhalten wird.

2. Verfahren nach Anspruch 1, **dadurch gekennzeichnet, dass** das Ausgangssignal des Mischers (10) zum Erhalt des oder wenigstens eines der Verzögerungssignale (SV1-SV3) einem oder mehreren Verzögerungselementen (15, 16, 17) zugeführt wird, das, insbesondere im eingeschwungen Zustand, eine Verzögerung bedingt, oder die zusammengenommen, insbesondere im eingeschwungenen Zustand, eine Verzögerung bedingen, die dem reziproken Wert einer vorgegebenen Frequenz oder einem Vielfachen des reziproken Werts einer vorgegebenen Frequenz entspricht.

3. Verfahren nach Anspruch 1 oder 2, **dadurch gekennzeichnet, dass** ein erstes, zweites und drittes Verzögerungselement (15, 16, 17) vorgesehen sind, und das Ausgangssignal des Mischers (10) mit dem ersten Verzögerungselement (15) verzögert wird, wodurch eine erstes Verzögerungssignal (SV1) erhalten wird, und das Ausgangssignal des Mischers (10) mit dem ersten und dem zweiten Verzögerungselement (15, 16) verzögert wird, wodurch ein zweites Verzögerungssignal (SV2) erhalten wird, und das Ausgangssignal des Mischers (10) mit dem ersten und dem zweiten und dem dritten Verzögerungselement (15, 16, 17) verzögert wird, wodurch ein drittes Verzögerungssignal (SV3) erhalten wird, und
die Differenz aus dem unverzögerten Signal (SU) und dem zweiten Verzögerungssignal (SV2) gebildet und als der Kontrollwert (vctrl) erachtet wird, und/oder die Summe aus dem unverzögerten Signal (SU) und dem zweiten Verzögerungssignal (SV2) gebildet und als der Kontrollwert (vctrl) erachtet wird, und
die Differenz aus dem ersten und dem zweiten Verzögerungssignal (SV1, SV2) gebildet und als zusätzlicher hoher Kontrollwert (vhigh) erachtet wird, und/oder die Summe aus dem ersten und dem zweiten Verzögerungssignal (SV1, SV2) gebildet und als zusätzlicher hoher Kontrollwert (vhigh) erachtet wird, und
die Differenz aus dem unverzögerten Signal (SU) und dem dritten Verzögerungssignal (SV3) gebildet und als zusätzlicher niedriger Kontrollwert (vlow) erachtet wird, und/oder die Summe aus dem unverzögerten Signal (SU) und dem dritten Verzögerungssignal (SV3) gebildet und als zusätzlicher niedriger Kontrollwert (vlow) erachtet wird, und
von dem Verhältnis des hohen und des niedrigen Kontrollwertes (vhigh, vlow) darauf geschlossen wird, ob die Mischfrequenz vergrößert oder verkleinert werden muss,
bevorzugt, wobei das erste und das dritte Verzögerungselement (15, 17) eine beliebige vorgegebene Verzögerung bedingen, und/oder das erste und das zweite Verzögerungselement (15, 16) zusammengenommen diejenige Verzögerung bedingen, die dem reziproken Wert der vorgegebenen Frequenz oder einem Vielfachen des reziproken Wertes der vorgegebenen Frequenz entspricht.

4. System zum Abgleichen einer Mischfrequenz eines Mischers und einer Trägerfrequenz eines von einem Empfänger (MD) empfangenen Signals, umfassend wenigstens einen insbesondere dem Empfänger (MD) zugeordneten oder von dem Empfänger (MD) umfassten Mischer (10) und wenigstens ein Verzögerungselement (15, 16, 17), wobei das System zur Durchführung des Verfahrens nach einem der Ansprüche 1 bis 3 ausgebildet und/oder eingerichtet ist.

5. Verfahren zur Positionsbestimmung, insbesondere Indoor-Positionsbestimmung, eines Empfängers (MD), der von mehreren Sendern (BS1-BS8) jeweils ein Signal bevorzugt kabellos empfängt, das sich durch eine Trägerfrequenz (fc1-fc8) und eine Modulationsfrequenz (fm+df) auszeichnet, wobei sich die Trägerfrequenzen (fc1-fc8) verschiedener Sender (BS1-BS8) voneinander unterscheiden, und die Modulationsfrequenz (fm+df) für aller Sender (BS1-BS8) gleich ist, bevorzugt, wobei die Modulationsfrequenz (fm+df) der Sender-Clockfrequenz (fsc) entspricht oder in einem festen, bevorzug ganzzahligen Verhältnis zu der Sender-Clockfrequenz (fsc) steht, insbesondere eine Harmonische oder Subharmonische der Sender-Clockfrequenz (fsc) ist, und die empfangenen Signale von dem Empfänger (MD) empfangen werden, bei dem wenigstens ein Mal unter Durchführung eines Verfahrens mit den Schritten
- das Signal wird einem Mischer (14), Frequenzabgleich-Mischer, in dem ein Mischen, insbesondere Heruntermischen mit einer Mischfrequenz erfolgt, die der Empfänger-Clockfrequenz (fec) entspricht oder in einem festen, bevorzugt ganzzahligen Verhältnis zu der Empfänger-Clockfrequenz (fec) steht, insbesondere eine Harmonische oder Subharmonische der Empfänger-Clockfrequenz (fec) ist, zugeführt insbesondere, um ein Ausgangssignal zu erhalten, das eine Frequenzkomponente enthält, die der aktuellen Frequenzdifferenz (df) zwischen der Sender-Clockfrequenz (fsc) und der Empfänger-Clockfrequenz (fec) entspricht,
- es wird ermittelt, ob die Frequenzkomponente des Ausgangssignals des Frequenzabgleich-Mischers (14) in einem festen, bevorzug ganzzahligen Verhältnis zu der Empfänger-Clockfrequenz (fec) steht, insbesondere eine Harmonische oder Subharmonische der Empfänger-Clockfrequenz (fec) ist, und
- für den Fall, dass dem nicht so ist, wird die Empfänger-Clockfrequenz (fec) und/oder die Sender-Clockfrequenz (fsc) angepasst, bevorzug derart, dass dies der Fall ist,
die Empfänger-Clockfrequenz (fec) und die Sender-Clockfrequenz (fsc) wenigstens eines der Sender (BS1-BS8) abgeglichen werden, und anschließend die Positionsbestimmung erfolgt, wobei
die von den Sendern (BS1-BS8) gesendeten und vom Empfänger (MD) empfangenen Signale, einem insbesondere dem Empfänger (MD) zugeordneten oder von dem Empfänger (MD) umfassten Mischer (10), insbesondere einer Gilbertzelle, zugeführt werden, in der sie mit einer Mischfrequenz gemischt, insbesondere heruntergemischt werden, und die Mischfrequenz dieses Mischers (10) vor der Positionsbestimmung wenigstens ein Mal unter Durchführung des Verfahrens nach Anspruch 1 oder 2 mit einer Trägerfrequenz eines von einem der Sender (BS1-BS8) stammenden Signals abgeglichen wird.

6. System (1) zur Positionsbestimmung, insbesondere zur Durchführung des Verfahrens nach Anspruch 5, umfassend wenigstens einen Empfänger (MD) und mehrere Sender (BS1-BS8), wobei die Sender (BS1-BS8) jeweils dazu ausgebildet und/oder eingerichtet sind, Signale insbesondere kabellos auszusenden, die sich jeweils durch eine Trägerfrequenz (fc1-fc8) und eine Modulationsfrequenz (fm+df) auszeichnen, wobei sich die Trägerfrequenzen (fc1-fc8) verschiedener Sender (BS1-BS8) voneinander unterscheiden, und die Modulationsfrequenz (fm+df) für aller Sender gleich ist, und ein System zum Abgleichen einer Sender-Clockfrequenz (fsc) und einer Empfänger-Clockfrequenz (fec)
umfassend wenigstens einen Mischer (14), Frequenzabgleich-Mischer, und wenigstens ein Verzögerungselement (15, 16, 17), wobei das System zum Abgleichen der Sender-Clockfrequenz (fsc) und der Empfänger-Clockfrequenz (fec) zur Durchführung eines Verfahrens mit den Schritten
- das Signal wird einem Mischer (14), Frequenzabgleich-Mischer, in dem ein Mischen, insbesondere Heruntermischen mit einer Mischfrequenz erfolgt, die der Empfänger-Clockfrequenz (fec) entspricht oder in einem festen, bevorzugt ganzzahligen Verhältnis zu der Empfänger-Clockfrequenz (fec) steht, insbesondere eine Harmonische oder Subharmonische der Empfänger-Clockfrequenz (fec) ist, zugeführt, insbesondere, um ein Ausgangssignal zu erhalten, das eine Frequenzkomponente enthält, die der aktuellen Frequenzdifferenz (df) zwischen der Sender-Clockfrequenz (fsc) und der Empfänger-Clockfrequenz (fec) entspricht,
- es wird ermittelt, ob die Frequenzkomponente des Ausgangssignals des Frequenzabgleich-Mischers (14) in einem festen, bevorzug ganzzahligen Verhältnis zu der Empfänger-Clockfrequenz (fec) steht, insbesondere eine Harmonische oder Subharmonische der Empfänger-Clockfrequenz (fec) ist, und
- für den Fall, dass dem nicht so ist, wird die Empfänger-Clockfrequenz (fec) und/oder die Sender-Clockfrequenz (fsc) angepasst, bevorzug derart, dass dies der Fall ist,
ausgebildet und eingerichtet ist, und wobei das System zum Abgleichen der Sender-Clockfrequenz (fsc) und der Empfänger-Clockfrequenz (fec) Bestandteil des Empfängers (MD) oder diesem zugeordnet ist, und wobei das System (1) zur Positionsbestimmung zur Durchführung des Verfahrens nach einem der Ansprüche 1 bis 3 ausgebildet und/oder eingerichtet ist.

7. System (1) nach Anspruch 6, **dadurch gekennzeichnet, dass** der oder wenigstens einer der Empfänger (MD) eine Kanalauswahleinheit (6) aufweist, die wenigstens einen, bevorzugt mehrere Mischer (12), Kanalauswahl-Mischer, und wenigstens einen Filter (13) umfasst, insbesondere, wobei der oder die Kanalauswahl-Mischer (12) als digitale Mischer ausgebildet sind, bevorzugt, wobei der oder die Kanalauswahl-Mischer (12) jeweils wenigstens einen CORDIC umfassen oder durch wenigstens einen CORDIC gegeben sind.

8. System (1) nach Anspruch 6 oder 7, **dadurch gekennzeichnet, dass** der oder wenigstens einer der Empfänger (MD) eine Empfangseinheit (5) aufweist, die einen Mischer (10), der insbesondere eine Gilbertzelle umfasst oder durch eine Gilbertzelle gegeben ist, und bevorzugt einen A/D-Wandler (11) umfasst, insbesondere, wobei der Ausgang der Empfangseinheit (5) mit dem Eingang des oder im Falle mehrerer des ersten der Verzögerungselemente (15, 16, 17) gekoppelt oder koppelbar ist.

## Claims

1. Method for matching the mixing frequency of a mixer (10) in a receiver (MD) and the carrier frequency of a signal received by the receiver (MD), in which
a signal is received from the receiver (MD), preferably wirelessly, which has a carrier frequency without modulation, and the signal is mixed in particular, down-converted, in the mixer (10) at a mixing frequency, and the resulting output signal of the mixer (10) is, on the one hand, fed to at least one delay element (15, 16, 17) to obtain at least one delayed signal (SV1-SV3), and the output signal of the mixer (10) is, on the other hand, routed past the at least one delay element (15, 16, 17) to additionally obtain an undelayed signal (SU), and
the difference and/or the sum of the delayed signal (SV1-SV3) or of at least one of the delayed signals (SV1- SV3) and the undelayed signal (SU) is calculated and considered as a control value (vctrl), and the mixing frequency of the mixer (10) is adjusted, as needed, such that the difference is reduced, in particular such that a minimum value of the difference is obtained and/or that the sum is increased, in particular such that a maximum value of the sum is obtained.

2. Method according to claim 1, **characterized in that** the output signal of the mixer (10) is fed to one or more delay elements (15, 16, 17), which particularly in the steady-state condition, causes a delay, or which, taken together, particularly in the steady-state condition, cause a delay corresponding to the reciprocal of a predetermined frequency or a multiple of the reciprocal of a predetermined frequency.

3. Method according to claim 1 or 2, **characterized in that** a first, second, and third delay element (15, 16, 17) are provided, and the output signal of the mixer (10) is delayed by the first delay element (15), thereby obtaining a first delayed signal (SV1), and the output signal of the mixer (10) is delayed by the first and second delay element (15, 16), thereby obtaining a second delayed signal (SV2), and the output signal of the mixer (10) is delayed by the first, second, and third delay elements (15, 16, 17), thereby obtaining a third delayed signal (SV3), and
the difference between the undelayed signal (SU) and the second delayed signal (SV2) is calculated and considered as the control value (vctrl), and/or the sum of the undelayed signal (SU) and the second delayed signal (SV2) is calculated and considered as the control value (vctrl), and
the difference between the first and second delayed signal (SV1, SV2) is calculated and considered as an additional high control value (vhigh), and/or the sum of the first and second delayed signal (SV1, SV2) is calculated and considered as an additional high control value (vhigh), and
the difference between the undelayed signal (SU) and the third delayed signal (SV3) is calculated and considered as an additional low control value (vlow), and/or the sum of the undelayed signal (SU) and the third delayed signal (SV3) is calculated and considered an additional low control value (vlow), and
the ratio of the high and low control values (vhigh, vlow) is used to determine whether the mixing frequency must be increased or decreased,
preferably, wherein the first and third delay element (15, 17) cause an arbitrarily predetermined delay, and/or the first and second delay element (15, 16) together cause a delay corresponding to the reciprocal of the predetermined frequency or a multiple of the reciprocal of the predetermined frequency.

4. System for matching the mixing frequency of a mixer and a carrier frequency of a signal received by a receiver (MD), comprising at least one mixer (10), in particular a mixer being associated with or being comprised by the receiver (MD), and at least one delay element (15, 16, 17), the system being embodied and/or configured to carry out the method according to one of claims 1 to 3.

5. Method for determining the position, in particular for determining the indoor position, of a receiver (MD) that receives a signal, preferably wirelessly, from each of several transmitters (BS1-BS8), which signal is **characterized by** a carrier frequency (fc1-fc8) and a modulation frequency (fm+df), wherein the carrier frequencies (fc1-fc8) of different transmitters (BS1-BS8) differ from one another, and the modulation frequency (fm+df) is preferably the same for all transmitters (BS1-BS8), wherein the modulation frequency (fm+df) corresponds to the transmitter clock frequency (fsc) or is in a fixed, preferably integer, ratio to the transmitter clock frequency (fsc), in particular is a harmonic or subharmonic of the transmitter clock frequency (fsc), and the received signals are received by the receiver (MD), in which, at least once, a method is performed comprising the steps
- the signal is fed to a mixer (14), frequency-matching mixer, in which mixing, in particular down-conversion, takes place at a mixing frequency that corresponds to the receiver clock frequency (fec) or is in a fixed, preferably integer, ratio to the receiver clock frequency (fec), in particular is a harmonic or subharmonic of the receiver clock frequency (fec), in particular, to obtain an output signal containing a frequency component that corresponds to the current frequency difference (df) between the transmitter clock frequency (fsc) and the receiver clock frequency (fec),
- it is determined whether the frequency component of the output signal of the frequency-matching mixer (14) is in a fixed, preferably integer ratio to the receiver clock frequency (fec), in particular whether it is a harmonic or subharmonic of the receiver clock frequency (fec), and
- if this is not the case, the receiver clock frequency (fec) and/or the transmitter clock frequency (fsc) are adjusted, preferably in such a way that this becomes the case,
the receiver clock frequency (fec) and the transmitter clock frequency (fsc) of at least one of the transmitters (BS1-BS8) are matched, and position determination is performed subsequently, wherein
the signals transmitted by the transmitters (BS1-BS8) and received by the receiver (MD) are fed to a mixer (10), in particular to a mixer being associated with (MD) or being comprised by the receiver (MD), in particular a Gilbert cell, where they are mixed, in particular down-converted at a mixing frequency, and the mixing frequency of this mixer (10) is matched at least once prior to position determination with a carrier frequency of a signal originating from one of the transmitters (BS1-BS8) by performing the method according to claim 1 or 2.

6. System (1) for determining a position, in particular for carrying out the method according to claim 5, comprising at least one receiver (MD) and a plurality of transmitters (BS1-BS8), wherein the transmitters (BS1-BS8) are each embodied and/or configured to transmit signals, in particular wirelessly, which are each **characterized by** a carrier frequency (fc1-fc8) and a modulation frequency (fm+df), wherein the carrier frequencies (fc1-fc8) of different transmitters (BS1-BS8) differ from one another, and the modulation frequency (fm+df) is the same for all transmitters, and a system for matching a transmitter clock frequency (fsc) and a receiver clock frequency (fec)
comprising at least one mixer (14), frequency-matching mixer, and at least one delay element (15, 16, 17), wherein the system for matching the transmitter clock frequency (fsc) and the receiver clock frequency (fec) is embodied and configured to perform a method comprising the steps
- the signal is fed to a mixer (14), frequency-matching mixer, in which mixing, in particular down-conversion, takes place at a mixing frequency that corresponds to the receiver clock frequency (fec) or is in a fixed, preferably integer, ratio to the receiver clock frequency (fec), in particular is a harmonic or subharmonic of the receiver clock frequency (fec), in particular, to obtain an output signal containing a frequency component that corresponds to the current frequency difference (df) between the transmitter clock frequency (fsc) and the receiver clock frequency (fec),
- it is determined whether the frequency component of the output signal of the frequency-matching mixer (14) is in a fixed, preferably integer, ratio to the receiver clock frequency (fec), in particular whether it is a harmonic or subharmonic of the receiver clock frequency (fec), and
- if this is not the case, the receiver clock frequency (fec) and/or the transmitter clock frequency (fsc) are adjusted, preferably in such a way that this becomes the case,
and wherein the system for matching the transmitter clock frequency (fsc) and the receiver clock frequency (fec) is an integral part of the receiver (MD) or is associated with it, and wherein the positioning system (1) for determining the position is embodied and/or configured to carry out the method according to one of claims 1 to 3.

7. System (1) according to claim 6, **characterized in that** the receiver (MD) or at least one of the receivers (MD) comprises a channel-selection unit (6) that includes at least one, preferably several mixers (12), channel-selection mixers, and at least one filter (13), in particular, wherein the channel-selection mixer or mixers (12) are embodied as digital mixers, preferably, wherein the channel-selection mixer or mixers (12) each comprise at least one a CORDIC, or are embodied as at least one CORDIC.

8. System (1) according to claim 6 or 7, **characterized in that** the receiver (MD) or at least one of the receivers (MD) comprises a receiving unit (5) that includes a mixer (10), which in particular comprises a Gilbert cell or is provided by a Gilbert cell, and preferably comprises an A/D converter (11), in particular wherein the output of the receiving unit (5) is coupled or can be coupled to the input of the delay element (15, 16, 17) or, in the case of multiple delay elements (15, 16, 17), to the input of the first delay element (15, 16, 17).

## Revendications

1. Procédé d'alignement de la fréquence de mélange d'un mélangeur (10) d'un récepteur (MD) et de la fréquence porteuse d'un signal reçu par le récepteur (MD), dans lequel
un signal est reçu de préférence sans fil par le récepteur (MD), lequel signal présente une fréquence porteuse sans modulation, et ce signal est mélangé, en particulier abaissé en fréquence, dans le mélangeur (10) avec une fréquence de mélange, et le signal de sortie obtenu du mélangeur (10) est, d'une part, acheminé vers au moins un élément à retard (15, 16, 17) afin d'obtenir au moins un signal retardé (SV1-SV3), et
d'autre part, le signal de sortie du mélangeur (10) est acheminé en contournant ledit au moins un élément de retard (15, 16, 17) afin d'obtenir en outre un signal non retardé (SU), et
la différence et/ou la somme entre le ou au moins l'un des signaux retardés (SV1-SV3) et le signal non retardé (SU) est déterminée et considérée comme une valeur de contrôle (vctrl), et la fréquence de mélange du mélangeur (10) est ajustée si nécessaire de telle sorte que la différence soit réduite, en particulier qu'une valeur minimale de celle-ci soit obtenue, et/ou que la somme soit augmentée, en particulier qu' une valeur maximale de celle-ci soit obtenue.

2. Procédé selon la revendication 1, **caractérisé en ce que** le signal de sortie du mélangeur (10) est acheminé, pour obtenir le ou au moins l'un des signaux retardés (SV1-SV3), vers un ou plusieurs éléments de retard (15, 16, 17) qui, en particulier à l'état stabilisé, induisent un retard, ou qui, pris ensemble, en particulier à l'état stabilisé, induisent un retard correspondant à la valeur réciproque d'une fréquence prédéfinie ou à un multiple de la valeur réciproque d'une fréquence prédéfinie.

3. Procédé selon la revendication 1 ou 2, **caractérisé en ce qu'**un premier, un deuxième et un troisième éléments de retard (15, 16, 17) sont prévus, et le signal de sortie du mélangeur (10) est retardé par le premier élément de retard (15), ce qui permet d'obtenir un premier signal retardé (SV1), et le signal de sortie du mélangeur (10) est retardé par les premier et deuxième éléments de retard (15, 16) est retardé, ce qui permet d'obtenir un deuxième signal retardé (SV2), et le signal de sortie du mélangeur (10) est retardé par les premier, deuxième et troisième éléments de retard (15, 16, 17), ce qui permet d'obtenir un troisième signal de retard (SV3), et
la différence entre le signal non retardé (SU) et le deuxième signal retardé (SV2) est calculée et considérée comme la valeur de contrôle (vctrl), et/ou la somme du signal non retardé (SU) et du deuxième signal retardé (SV2) est calculée et considérée comme la valeur de commande (vctrl), et
la différence entre le premier et le deuxième signal retardé (SV1, SV2) est calculée et considérée comme une valeur de contrôle haute supplémentaire (vhigh), et/ou la somme du premier et du deuxième signal retardé (SV1, SV2) est calculée et considérée comme une valeur de contrôle haute supplémentaire (vhigh), et
la différence entre le signal non retardé (SU) et le troisième signal retardé (SV3) est calculée et considérée comme une valeur de contrôle basse supplémentaire (vlow), et/ou la somme du signal non retardé (SU) et du troisième signal retardé (SV3) est calculée et considérée comme une valeur de contrôle basse supplémentaire (vlow), et
le rapport entre les valeurs de contrôle haute et basse (vhigh, vlow) permet de déterminer s'il faut augmenter ou diminuer la fréquence de mélange,
de préférence, les premier et troisième éléments de retard (15, 17) provoquant un retard prédéfini quelconque, et/ou les premier et deuxième éléments de retard (15, 16) provoquent, pris ensemble, le retard correspondant à la valeur inverse de la fréquence prédéfinie ou à un multiple de la valeur inverse de la fréquence prédéfinie.

4. Système permettant d'aligner une fréquence de mélange d'un mélangeur et une fréquence porteuse d'un signal reçu par un récepteur (MD), comprenant au moins un mélangeur (10), associé en particulier au récepteur (MD) ou intégré à celui-ci, et au moins un élément à retard (15, 16, 17), le système étant conçu et/ou agencé pour mettre en œuvre le procédé selon l'une des revendications 1 à 3.

5. Procédé de détermination de la position, en particulier de la position en intérieur, d'un récepteur (MD) qui reçoit de plusieurs émetteurs (BS1-BS8) respectivement un signal, de préférence sans fil, **caractérisé par** une fréquence porteuse (fc1-fc8) et une fréquence de modulation (fm+df), les fréquences porteuses (fc1-fc8) des différents émetteurs (BS1-BS8) diffèrent les unes des autres, et la fréquence de modulation (fm+df) est de préférence identique pour tous les émetteurs (BS1-BS8), la fréquence de modulation (fm+df) correspondant à la fréquence d'horloge d'émetteur (fsc) ou se trouve dans un rapport fixe, de préférence entier, avec la fréquence d'horloge d'émetteur (fsc), en particulier est un harmonique ou un sous-harmonique de la fréquence d'horloge d'émetteur (fsc), et les signaux reçus sont captés par le récepteur (MD), dans lequel, au moins une fois, on met en œuvre un procédé comprenant les étapes suivantes :
- le signal est acheminé vers un mélangeur (14), un mélangeur d'alignement de fréquence, dans lequel a lieu un mélange, en particulier une conversion vers le bas, avec une fréquence de mélange qui correspond à la fréquence d'horloge de récepteur (fec) ou qui présente un rapport fixe, de préférence entier, avec la fréquence d'horloge de récepteur (fec), en particulier une harmonique ou une sous-harmonique de la fréquence d'horloge de récepteur (fec), en particulier afin d'obtenir un signal de sortie contenant une composante de fréquence correspondant à la différence de fréquence actuelle (df) entre la fréquence d'horloge d'émetteur (fsc) et la fréquence d'horloge de récepteur (fec),
- on détermine si la composante de fréquence du signal de sortie du mélangeur d'alignement de fréquence (14) présente un rapport fixe, de préférence entier, avec la fréquence d'horloge de récepteur (fec), en particulier s'il s'agit d'un harmonique ou d'un sous-harmonique de la fréquence d'horloge de récepteur (fec), et
- dans le cas contraire, la fréquence d'horloge de récepteur (fec) et/ou la fréquence d'horloge d'émetteur (fsc) sont ajustées, de préférence de manière à ce que ce soit le cas,
la fréquence d'horloge de récepteur (fec) et la fréquence d'horloge d'émetteur (fsc) d'au moins l'un des émetteurs (BS1-BS8) sont synchronisées, puis la détermination de la position est effectuée,
les signaux émis par les émetteurs (BS1-BS8) et reçus par le récepteur (MD) sont acheminés vers un mélangeur (10), en particulier associé au récepteur (MD) ou intégré à celui-ci, en particulier une cellule de Gilbert, dans laquelle ils sont mélangés à une fréquence de mélange, en particulier abaissés en fréquence, et la fréquence de mélange de ce mélangeur (10) est alignée au moins une fois, avant la détermination de la position, en appliquant le procédé selon la revendication 1 ou 2, avec une fréquence porteuse d'un signal provenant de l'un des émetteurs (BS1-BS8).

6. Système (1) de détermination de position, en particulier pour la mise en œuvre du procédé selon la revendication 5, comprenant au moins un récepteur (MD) et plusieurs émetteurs (BS1-BS8), les émetteurs (BS1-BS8) étant chacun conçus et/ou agencés pour émettre, en particulier sans fil, des signaux qui se caractérisent chacun par une fréquence porteuse (fc1-fc8) et d'une fréquence de modulation (fm+df), les fréquences porteuses (fc1-fc8) des différents émetteurs (BS1-BS8) étant différentes les unes des autres, et la fréquence de modulation (fm+df) étant identique pour tous les émetteurs, et un système destiné à synchroniser une fréquence d'horloge d'émetteur (fsc) et une fréquence d'horloge de récepteur (fec)
comprenant au moins un mélangeur (14), mélangeur d'alignement de fréquence, et au moins un élément de retard (15, 16, 17), le système d'alignement de la fréquence d'horloge d'émetteur (fsc) et de la fréquence d'horloge de récepteur (fec) étant destiné à mettre en œuvre un procédé comprenant les étapes suivantes
- le signal est acheminé vers un mélangeur (14), mélangeur d'alignement de fréquence, dans lequel s'effectue un mélange, en particulier une conversion descendante, à une fréquence de mélange qui correspond à la fréquence d'horloge de récepteur (fec) ou qui présente un rapport fixe, de préférence entier, avec la fréquence d'horloge de récepteur (fec), en particulier une harmonique ou une sous-harmonique de la fréquence d'horloge de récepteur (fec), en particulier afin d'obtenir un signal de sortie contenant une composante de fréquence correspondant à la différence de fréquence actuelle (df) entre la fréquence d'horloge d'émetteur (fsc) et la fréquence d'horloge de récepteur (fec),
- on détermine si la composante de fréquence du signal de sortie du mélangeur d'alignement de fréquence (14) présente un rapport fixe, de préférence entier, avec la fréquence d'horloge de récepteur (fec), en particulier s'il s'agit d'un harmonique ou d'un sous-harmonique de la fréquence d'horloge de récepteur (fec), et
- dans le cas contraire, la fréquence d'horloge de récepteur (fec) et/ou la fréquence d'horloge d'émetteur (fsc) sont ajustées, de préférence de manière à ce que ce soit le cas,
conçu et agencé à cet effet, le système destiné à synchroniser la fréquence d'horloge d'émetteur (fsc) et la fréquence d'horloge de récepteur (fec) faisant partie intégrante du récepteur (MD) ou étant associé à celui-ci, et le système (1) de détermination de position étant conçu et/ou agencé pour mettre en œuvre le procédé selon l'une des revendications 1 à 3.

7. Système (1) selon la revendication 6, **caractérisé en ce que** le récepteur (MD) ou au moins l'un d'entre eux comporte une unité de sélection de canaux (6) qui comprend au moins un, de préférence plusieurs mélangeurs (12), mélangeurs de sélection de canaux, et au moins un filtre (13), en particulier, le ou les mélangeurs de sélection de canaux (12) étant conçus comme des mélangeurs numériques, de préférence, le ou les mélangeurs de sélection de canaux (12) comprenant chacun au moins un CORDIC ou étant constitués d'au moins un CORDIC.

8. Système (1) selon la revendication 6 ou 7, **caractérisé en ce que** le récepteur (MD) ou au moins l'un d'entre eux comporte une unité de réception (5) qui comprend un mélangeur (10), comprenant en particulier une cellule de Gilbert ou étant constitué d'une cellule de Gilbert, et de préférence un convertisseur A/N (11), la sortie de l'unité de réception (5) est couplée ou peut être couplée à l'entrée du premier des éléments de retard (15, 16, 17) ou, s'il y en a plusieurs, au premier d'entre eux.
